# EUROPEAN PATENT SPECIFICATION

(11) **EP 2 917 943 B1**
(45) Date of publication and mention of the grant of the patent: **05.10.2016**
(21) Application number: 13795398.0
(22) Date of filing: 12.11.2013
(51) Int. Cl.: H01L 31/048

(54) **PHOTOVOLTAIC CELL MODULE**
PHOTOVOLTAIKZELLENMODUL
MODULE DE CELLULE PHOTOVOLTAÏQUE

(30) Priority: 12.11.2012 US 201261725249 P
(43) Date of publication of application: 16.09.2015
(73) Proprietor: Dow Corning Corporation, Midland, Michigan 48686-0994 (US)
(72) Inventor: BLACKWOOD, William, R., Midland, MI 48642 (US); JAMES, Richard, Midland, MI 48642 (US); KETOLA, Barry, M., Freeland, MI 48623 (US); MILNE, Jacob, Wheeler, MI 48662 (US); ORLOWSKI, Elizabeth, A., Midland, MI 48642 (US)
(74) Representative: Fyfe, Fiona Allison Watson
(86) International application number: PCT/US2013/069642
(87) International publication number: WO 2014/075058

(56) References cited:
- WO-A1-2012/063946
- WO-A2-2007/011580
- WO-A2-2010/051355

## Description

Photovoltaic cells are included in photovoltaic cell modules that typically also include tie layers, substrates, superstrates, and/or additional materials that provide strength and stability. However, these materials tend to be expensive. Use of less expensive materials has historically caused photovoltaic cell modules to fail one or more physical tests, such as the well known Wet Leakage Current Test. Accordingly, there remains an opportunity to develop an improved photovoltaic cell module.

WO 2012/063946 A1 discloses solar cell modules comprising a back sheet comprising a polyester substrate layer with an external silicone based resin coating layer

### SUMMARY OF THE DISCLOSURE

In one embodiment, the instant disclosure provides a photovoltaic cell module including a first outermost layer having a light transmittance of at least 70 percent as determined by UV/Vis spectrophotometry using ASTM E424-71 (2007). The photovoltaic cell module also includes a photovoltaic cell disposed on the first outermost layer, a backsheet disposed on the photovoltaic cell, and a second outermost layer opposite the first outermost layer. The second outermost layer is disposed on an outward facing surface of the backsheet sandwiching the photovoltaic cell and the backsheet between the second outermost layer and the first outermost layer. The second outermost layer is present in a coating weight of from 3 to 75 grams per meter squared (g/m²) of the outward facing surface of the backsheet. Furthermore, the backsheet and the second outermost layer each independently consist essentially of a silicone. The photovoltaic cell module passes the Wet Leakage Current Test at a voltage of at least 1000 V using IEC 61215 after humidity cycling for 1,000 hours. This disclosure also provides a method of forming the photovoltaic cell module. The method includes the step of assembling the first outermost layer, the photovoltaic cell, the backsheet, and the second outermost layer.

### BRIEF DESCRIPTION OF THE DRAWINGS

Other advantages of the present disclosure will be readily appreciated, as the same becomes better understood by reference to the following detailed description when considered in connection with the accompanying drawings which represent various non-limiting embodiments of this disclosure.

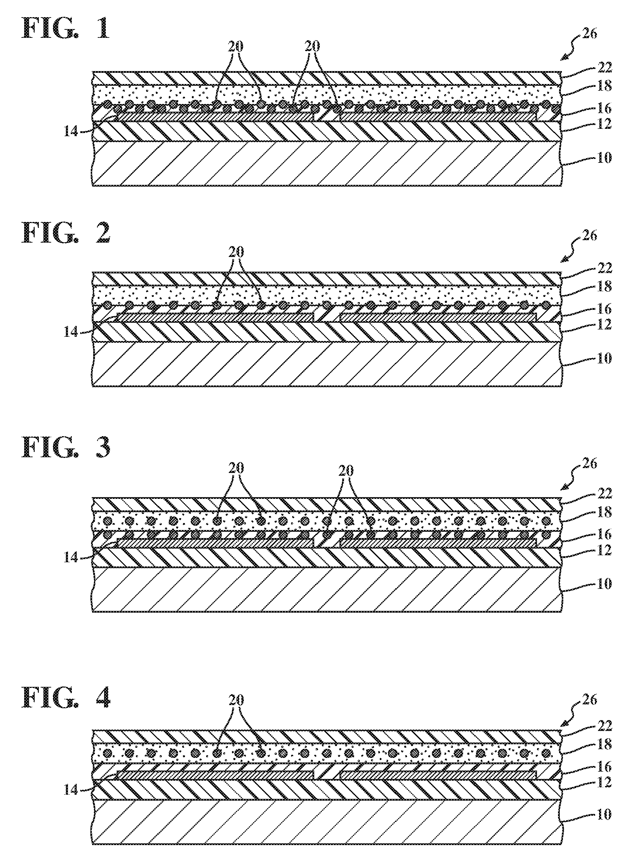

Figure 1 is a side cross-sectional view of an embodiment of the photovoltaic cell module that includes a first outermost layer, a first encapsulant disposed on and in direct contact with the first outermost layer, a photovoltaic cell disposed on and in direct contact with the first encapsulant, a second encapsulant disposed on and in direct contact with both the photovoltaic cell and the first encapsulant, the backsheet disposed on and in direct contact with the second encapsulant, a textile disposed within the second encapsulant and on and in direct contact with both the second encapsulant and the backsheet, and a second outermost layer disposed on and in direct contact with the backsheet.
Figure 2 is a side cross-sectional view of another embodiment of the photovoltaic cell module that includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the backsheet disposed on and in direct contact with the second encapsulant, the textile disposed on and in direct contact with both the second encapsulant and the backsheet, and the second outermost layer disposed on and in direct contact with the backsheet.
Figure 3 is a side cross-sectional view of yet another embodiment of the photovoltaic cell module that includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the backsheet disposed on and in direct contact with the second encapsulant, the textile disposed within both the second encapsulant and the backsheet, and the second outermost layer disposed on and in direct contact with the backsheet.
Figure 4 is a side cross-sectional view of one embodiment of the photovoltaic cell module that includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the backsheet disposed on and in direct contact with the second encapsulant, the textile disposed within the backsheet, and the second outermost layer disposed on and in direct contact with the backsheet.

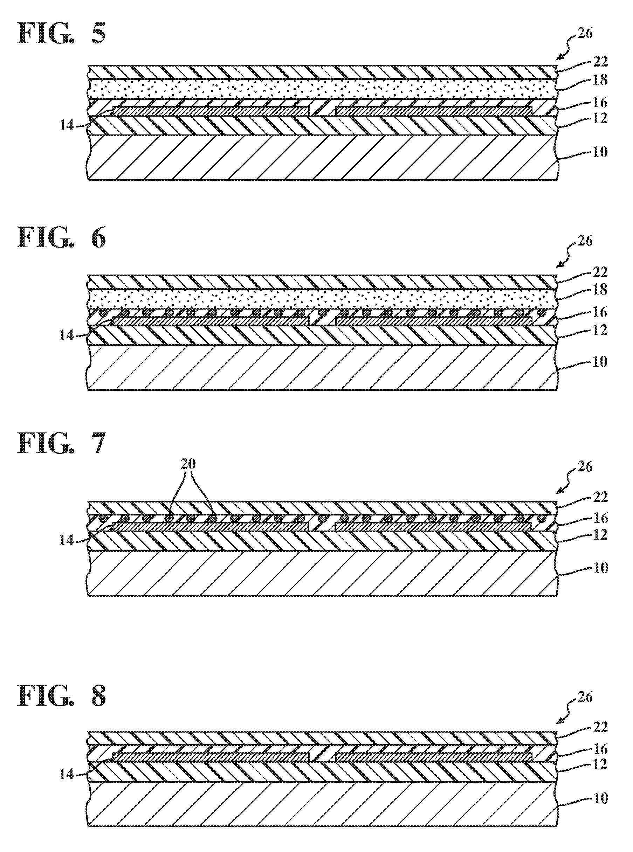

Figure 5 is a side cross-sectional view of yet another embodiment of the photovoltaic cell module that includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the backsheet disposed on and in direct contact with the second encapsulant, and the second outermost layer disposed on and in direct contact with the backsheet.
Figure 6 is a side cross-sectional view of yet another embodiment of the photovoltaic cell module that includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the textile disposed within the second encapsulant, the backsheet disposed on and in direct contact with the second encapsulant, and the second outermost layer disposed on and in direct contact with the backsheet.
Figure 7 is a side cross-sectional view of yet another embodiment of the photovoltaic cell module that includes the first outermost layer, the first encapsulant disposed on and in direct contact with the first outermost layer, the photovoltaic cell disposed on and in direct contact with the first encapsulant, the second encapsulant, functioning as the backsheet, disposed on and in direct contact with both the photovoltaic cell and the first encapsulant, the textile disposed within the second encapsulant, and the second outermost layer disposed on and in direct contact with the second encapsulant.
Figure 8 is a side cross-sectional view of yet another embodiment of the photovoltaic cell module that includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, and the second outermost layer disposed on and in direct contact with the second encapsulant.

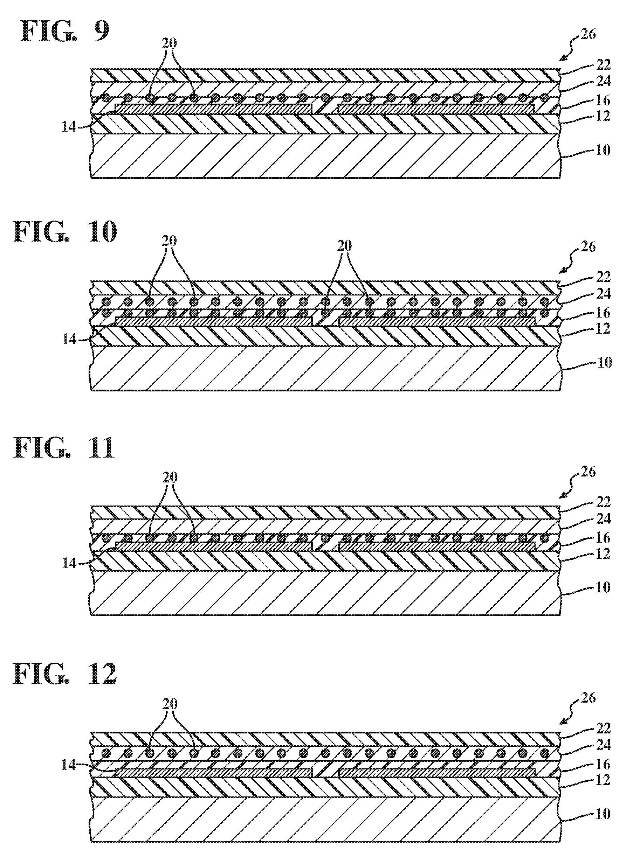

Figure 9 is a side cross-sectional view of yet another embodiment of the photovoltaic cell module that includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer, functioning as the backsheet, disposed on and in direct contact with the second encapsulant, the textile disposed on and in direct contact with both the second encapsulant and the tie layer, and the second outermost layer disposed on and in direct contact with the tie layer.
Figure 10 is a side cross-sectional view of yet another embodiment of the photovoltaic cell module that includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer, functioning as the backsheet, disposed on and in direct contact with the second encapsulant, the textile disposed within both the second encapsulant and the tie layer, and the second outermost layer disposed on and in direct contact with the tie layer.
Figure 11 is a side cross-sectional view of another embodiment of the photovoltaic cell module that includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the textile disposed within the second encapsulant, the tie layer, functioning as the backsheet, disposed on and in direct contact with the second encapsulant, and the second outermost layer disposed on and in direct contact with the tie layer.
Figure 12 is a side cross-sectional view of yet another embodiment of the photovoltaic cell module that includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer, functioning as the backsheet, disposed on and in direct contact with the second encapsulant, the textile disposed within the tie layer, and the second outermost layer disposed on and in direct contact with the tie layer.

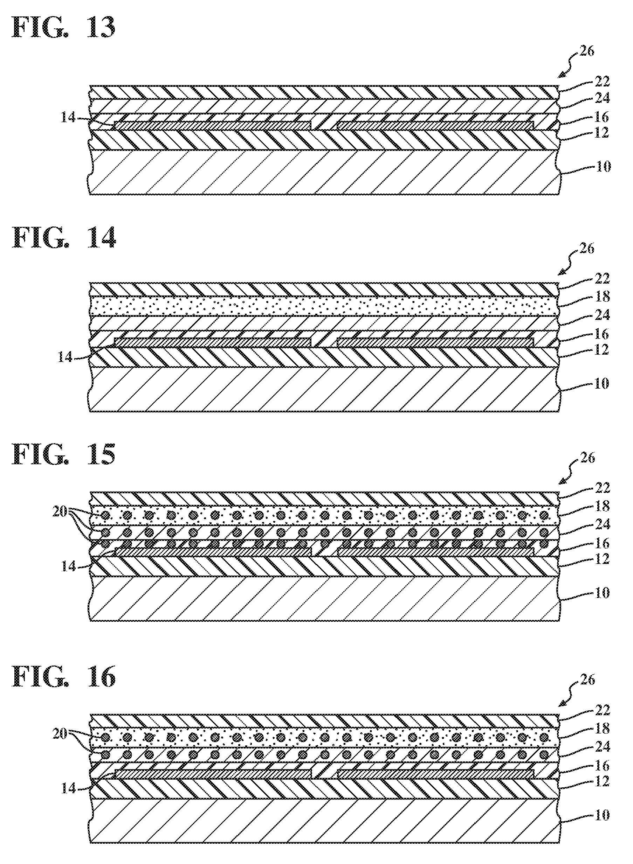

Figure 13 is a side cross-sectional view of yet another embodiment of the photovoltaic cell module that includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer, functioning as the backsheet, disposed on and in direct contact with the second encapsulant, and the second outermost layer disposed on and in direct contact with the tie layer.
Figure 14 is a side cross-sectional view of yet another embodiment of the photovoltaic cell module that includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer disposed on and in direct contact with the second encapsulant, the backsheet disposed on and in direct contact with the tie layer, and the second outermost layer disposed on and in direct contact with the backsheet.
Figure 15 is a side cross-sectional view of another embodiment of the photovoltaic cell module that includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer disposed on and in direct contact with the second encapsulant, the backsheet disposed on and in direct contact with the tie layer, the textile disposed within all the second encapsulant, the tie layer and the backsheet, and the second outermost layer disposed on and in direct contact with the backsheet.
Figure 16 is a side cross-sectional view of another embodiment of the photovoltaic cell module that includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer disposed on and in direct contact with the second encapsulant, the backsheet disposed on and in direct contact with the tie layer, the textile disposed within both the tie layer and the backsheet, and the second outermost layer disposed on and in direct contact with the backsheet.

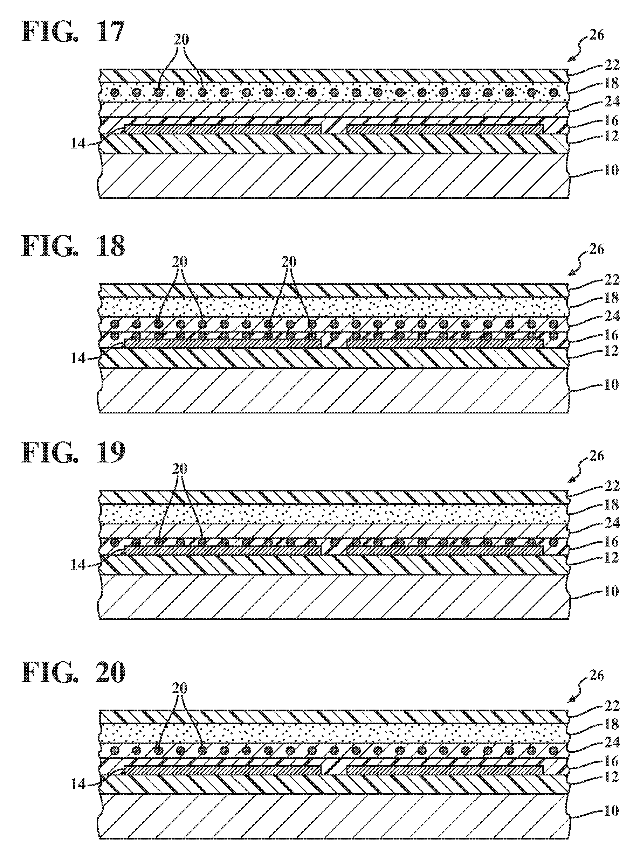

Figure 17 is a side cross-sectional view of yet another embodiment of the photovoltaic cell module that includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer disposed on and in direct contact with the second encapsulant, the backsheet disposed on and in direct contact with the tie layer, the textile disposed within the backsheet, and the second outermost layer disposed on and in direct contact with the backsheet.
Figure 18 is a side cross-sectional view of another embodiment of the photovoltaic cell module that includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer disposed on and in direct contact with the second encapsulant, the textile disposed within both the second encapsulant and the tie layer, the backsheet disposed on and in direct contact with the tie layer, and the second outermost layer disposed on and in direct contact with the backsheet.
Figure 19 is a side cross-sectional view of yet another embodiment of the photovoltaic cell module that includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the textile disposed within the second encapsulant, the tie layer disposed on and in direct contact with the second encapsulant, the backsheet disposed on and in direct contact with the tie layer, and the second outermost layer disposed on and in direct contact with the backsheet.
Figure 20 is a side cross-sectional view of another embodiment of the photovoltaic cell module that includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer disposed on and in direct contact with the second encapsulant, the textile disposed within the tie layer, the backsheet disposed on and in direct contact with the tie layer, and the second outermost layer disposed on and in direct contact with the backsheet.

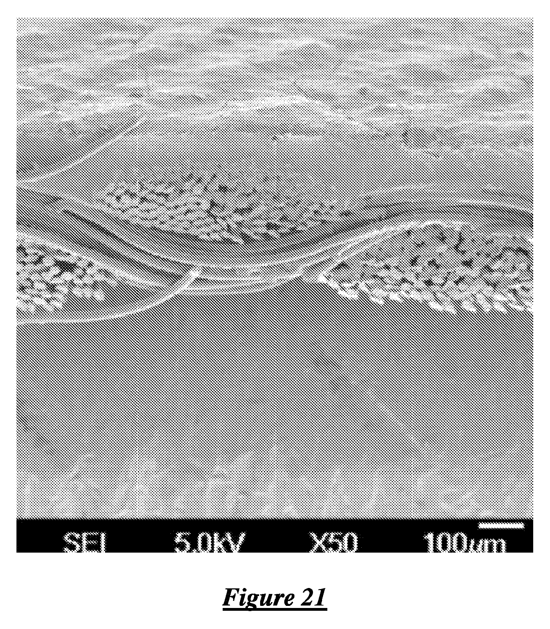

Figure 21 is a scanning electron micrograph (SEM) of a backsheet, including a textile, that includes a second outermost layer disposed thereon.

### DETAILED DESCRIPTION OF THE DISCLOSURE

The present disclosure provides a photovoltaic cell module (26) (hereinafter referred to as a "module") generally shown in the Figures and a method of forming the module (26). A series of modules (26), e.g. at least two modules (26), may be electrically connected and form a photovoltaic array. The photovoltaic array may be planar or non-planar and typically functions as a single electricity producing unit wherein the modules are interconnected in such a way as to generate voltage.

The module (26) may have various physical properties. Typically, the module (26) passes the Wet Leakage Current Test at a voltage (V) of at least 1000, 1025, 1050, 1075, 1100, 1125, 1150, 1175, 1200, 1225, 1250, 1275, 1300, 1325, 1350, 1375, 1400, 1425, 1450, 1475, 1500, V using IEC 61215 after humidity cycling for 1,000, 1,100, 1,200, 1,300, 1,400, 1,500, 1,600, 1,700, 1,800, 1,900, or 2,000, hours. As is known in the art, the wet leakage current test includes placing a module in an aqueous solution and applying an electrical field, e.g. a 1000 V field, and allowing the field to be applied for two minutes after which a current reading is taken. For larger modules, the wet leakage insulation resistance typically must be greater than 40 mega ohms/m². For smaller modules, the wet leakage resistance typically must be greater than 400 mega ohms/m². This test is typically performed during thermal cycle and damp heat aging initially and at all the test point intervals through two times IEC (TC 400, DH 2000).

The module (26) may exhibit a water vapor transmission rate (WVTR) of 5 to 12, 6 to 11, 7 to 10, 8 to 9, 5, 6, 7, 8, 9, 10, 11, or 12, grams per meters squared per day (g/m²/day) according to any method known in the art. More specifically, the aforementioned WVTR values may apply to the backsheet (18), the second outermost layer (22), or the combination of the backsheet (18) and the second outermost layer (22), e.g. the bi-layer backsheet described in greater detail below. The differently, the module (26) as a whole may be evaluated to determine WVTR and/or one or more of the backsheet (18), the second outermost layer (22), or the combination of the backsheet (18) and the second outermost layer (22), may be evaluated to determine WVTR.

The module (26) includes a first (outermost) layer (10), a photovoltaic cell (14) disposed on the first (outermost) layer (10), a backsheet (18) disposed on the photovoltaic cell (14), and a second outermost layer (22) opposite the first (outermost) layer (10). The second outermost layer (22) is disposed on an outward facing surface of the backsheet (18) sandwiching the photovoltaic cell (14) and the backsheet (18) between the second outermost layer (22) and the first (outermost) layer (10).

The module (26) may be described as set forth immediately above or may alternatively be described as further including one or more electrical components (e.g. leads, wires, electrodes, junction boxes), one or more additional structural components (e.g. frames, mounts), one or more tie layers (24), and/or any components typically found in or near photovoltaic cell (14) modules during production, installation, and/or use. The module (26) further including one or more additional electrical or structural components may be described as a photovoltaic cell panel. In one embodiment, the photovoltaic cell (14) module (26) (not including junction boxes, leads) is free of organic polymers. Alternatively, the photovoltaic cell (14) module (26) may include only silicone polymers, i.e., linear and/or branched polyorganosiloxanes.

### First (Outermost) Layer:

The module (26) includes a first layer that has a light transmittance of at least 70 percent as determined using UV/Vis spectrophotometry using ASTM E424-71 (2007). In various embodiments, the first layer (10) has a light transmittance of at least 75, 80, 85, 90, 91, 92, 93, 94, 95, 96, 97, 98, or 99, percent, wherein the light transmittance is at most 100 percent. In an alternative embodiment, the first layer has a light transmittance of approximately 100 percent (e.g. from 99.5% to 100.0%). Typically, the first layer (10) is further defined as a first "outermost" layer (10) when the first layer is an exterior layer of the module (26). However, the first layer (10) may be at least partially coated with silicon and oxygen based materials (SiO_{X}) which may be any one or more silicones, i.e., linear and/or branched polyorganosiloxanes, described below or may be different. In this case, the coating of the SiOₓ material would be the "outermost" layer and the first layer (10) would be, at least in some areas, a layer interior to the coating. Simply for descriptive, but non-limiting purposes, the first layer (10) is described as the first "outermost" layer (10) below. However, the terminology first layer (10) and first outermost layer (10) may be interchangeable herein in various embodiments.

The first outermost layer (10) may be, include, consist essentially of (and not include organic monomers or polymers), or consist of, silicone, i.e., linear and/or branched polyorganosiloxanes. The silicone is not particularly limited and may be any of the silicones described below or may be different. In one embodiment, the first outermost layer (10) is, includes, consists essentially of (and does not include organic monomers or polymers or silicones), or consists of, glass (e.g. an amorphous soda-lime glass). In another embodiment, the first outermost layer (10) is not limited to the aforementioned compounds and may include any compound or composition known in the art so long as the first outermost layer (10) has a light transmittance of at least 70 percent using ASTM E424-71 (2007).

Typically, the first outermost layer (10) provides protection to a front surface of the module (26). Similarly, the first outermost layer (10) may provide protection to a back surface of the module (26) depending on orientation of the module. The first outermost layer (10) may be soft and flexible or may be rigid and stiff. Alternatively, the first outermost layer (10) may include rigid and stiff segments while simultaneously including soft and flexible segments. The first outermost layer (10) may be load bearing or non load bearing and may be included in any portion of the module (26). The first outermost layer (10) may be a "top layer," also known as a superstrate. Typically, the first outermost layer (10) is positioned on a top of the module (26) and in front of a light source. The first outermost layer (10) may be used to protect the module (26) from environmental conditions such as rain, show, and heat. In one embodiment, the first outermost layer (10) has a length and width of 125 mm each. In another embodiment, the first outermost layer (10) has a length and width of 156 mm each. The first outermost layer (10), and the instant disclosure, are not limited to these dimensions.

### Photovoltaic Cell:

The module (26) also includes a photovoltaic cell (14). The photovoltaic cell (14) may be disposed on the first outermost layer (10) or the first outermost layer (10) may be disposed on the photovoltaic cell (14). In one embodiment, the photovoltaic cell (14) is disposed directly on the first outermost layer (10), i.e., in direct contact with the first outermost layer (10), e.g. by an encapsulant layer. In another embodiment, the photovoltaic cell (14) is spaced apart from the first outermost layer (10) yet still disposed "on" the first outermost layer (10). The photovoltaic cell (14) may be disposed on, and in direct contact with (i.e., directly applied to), the first outermost layer (10) via chemical vapor deposition and/or physical sputtering. Alternatively, the photovoltaic cell (14) may be formed apart from the first outermost layer (10) and/or the module (26) and later disposed on the first outermost layer (10).

The photovoltaic cell (14) typically has a thickness of from 50 to 250, more typically of from 100 to 225, and most typically of from 175 to 225, micrometers. In one embodiment, the photovoltaic cell (14) has a length and width of 125 mm each. In another embodiment, the photovoltaic cell (14) has a length and width of 156 mm each. The photovoltaic cell (14) is not limited to these dimensions.

The photovoltaic cell (14) may include large-area, single-crystal, single layer p-n junction diodes. These photovoltaic cells (14) are typically made using a diffusion process with silicon wafers. Alternatively, the photovoltaic cell (14) may include thin epitaxial deposits of (silicon) semiconductors on lattice-matched wafers. In this embodiment, the photovoltaic cell (14) may be classified as for use in either space or terrestrial applications and typically has AM0 efficiencies of from 7 to 40%. Further, the photovoltaic cell (14) may include quantum well devices such as quantum dots, quantum ropes, and the like, and also include carbon nanotubes. Still further, the photovoltaic cell (14) may include mixtures of polymers and nano particles that form a single multi-spectrum layer which can be stacked to make multi-spectrum solar cells more efficient and less expensive.

The composition of the photovoltaic cell (14) is not particularly limited and may include amorphous silicon, monocrystalline silicon, polycrystalline silicon, microcrystalline silicon, nanocrystalline silica, cadmium telluride, copper indium/gallium selenide/sulfide, gallium arsenide, polyphenylene vinylene, copper phthalocyanine, carbon fullerenes, and combinations thereof in ingots, ribbons, thin films, and/or wafers. The photovoltaic cell (14) may also include light absorbing dyes such as ruthenium organometallic dyes. Most typically, the photovoltaic cell (14) includes monocrystalline and polycrystalline silicon.

The photovoltaic cell (14) has a first side and a second side. Typically the first side is opposite the second side. A first electrical lead is typically disposed on the first side while a second electrical lead is typically disposed on the second side. The photovoltaic cell (14) may be alternatively described as a front-contact cell or a rear-contact cell. One of the first and second electrical leads typically acts as an anode while the other typically acts as a cathode. The first and second electrical leads may be the same or may be different and may include metals, conducting polymers, and combinations thereof. In one embodiment, the first and second electrical leads include tin-silver solder coated copper. In another embodiment, the first and second electrical leads include tin-lead solder coated copper.

The first and second electrical leads may be disposed on any part of the first and second sides of the photovoltaic cell (14). The first and second electrical leads may be of any size and shape and typically are rectangular-shaped and have dimensions of approximately 0.005 to 0.080 inches in length and/or width. The first and second electrical leads typically connect the module (26) to additional modules in a photovoltaic array. The modules may be connected in series or in parallel.

### Backsheet:

The module (26) also includes a backsheet (18) disposed on the photovoltaic cell (14). Alternatively, the photovoltaic cell (14) may be disposed on the backsheet (18). The backsheet (18) may bind the first outermost layer (10) and the photovoltaic cell (14) and/or at least partially encapsulate the photovoltaic cell (14). The backsheet (18) may be disposed directly on the photovoltaic cell (14), i.e., in direct contact with the photovoltaic cell (14), or may be spaced apart from the photovoltaic cell (14) (e.g. by an encapsulant layer) yet still be disposed "on" the photovoltaic cell (14). In various embodiments, the backsheet (18) is further described as a controlled bead disposed on the photovoltaic cell (14), e.g. a controlled bead of a liquid silicone composition, i.e., linear and/or branched polyorganosiloxanes. The controlled bead is typically applied in a rectangular shape. However, the controlled bead may be formed in any shape. The controlled bead may be in contact with an interior portion of the first outermost layer (10), the photovoltaic cell (14), or both the first outermost layer (10) and the photovoltaic cell (14) thereby leaving a space along a perimeter of the first outermost layer (10), the photovoltaic cell (14), or both the first outermost layer (10) and the photovoltaic cell (14) that does not include the backsheet (18). In one embodiment, this space is approximately ½ inch in width. The backsheet (18) and/or composition used to form the backsheet (18) may be described as a matrix in which the fibers are disposed in and/or encapsulated by a silicone, i.e., linear and/or branched polyorganosiloxanes. In such an embodiment, the backsheet (18) and/or composition used to form the backsheet (18), i.e., the "matrix," may be, include, consist essentially of, or consist of silicone and still include the plurality of fibers (20).

The backsheet (18) typically has a thickness of from 1 to 50, more typically of from 4 to 40, even more typically of from 3 to 30, and still more typically of from 4 to 15, and most typically of from 4 to 10, mils. The conversion for mils to various SI units is 0.0254 mm/mil or 25.4 microns/mil. The backsheet (18) may be tacky or non-tacky and may be a gel, gum, liquid, paste, resin, or solid. In one embodiment, the backsheet (18) is substantially free of entrapped air (bubbles). The terminology "substantially free" describes that the backsheet (18) has no visible air bubbles when viewed with the naked eye or under 10x magnification. The backsheet (18) may be formed from a liquid silicone composition and may be cured or partially cured to be tacky or non-tacky and/or a gel, gum, liquid, paste, resin, or solid. In one embodiment, partial curing occurs when less than 90 percent of appropriate (i.e., expected) reactive moieties react. In another embodiment, curing occurs when at least 90 percent of appropriate (i.e., expected) reactive moieties react, as determined by ²⁹Si NMR. The backsheet (18) may free of one or more of organic polymers, polymers other than silicones, polyethylene terephthalate, polyethylene naphthalate, polyvinyl fluoride, and/or ethylene vinyl acetate. The backsheet (18) may be free of Tedlar^{®}. Typically, the backsheet is free of all polymers that are not silicone polymers. The differently, the backsheet is typically a silicone or consists essentially of a silicone (and is free from non-silicone polymers), or consists of one or more silicones.

In one embodiment, the backsheet (18) includes single fiber or a plurality of fibers (20), as shown in the Figures. In another embodiment, the backsheet (18) is free of the plurality of fibers (20) and also of single fibers. The plurality of fibers (20) may be present in the backsheet (18), e.g. at least partially encapsulated by the backsheet (18), independent from the backsheet (18), or both. The backsheet (18) may include at least two or a plurality of individual fibers.

The terminology "fiber" includes continuous filaments and/or discrete lengths of materials that may be natural or synthetic. Natural fibers include, but are not limited to, those produced by plants, animals, and geological processes such as vegetable, wood, animal, and natural mineral fibers. Synthetic fibers include, but are not limited to, non-natural mineral fibers such as fiberglass, metallic fibers, carbon fibers, polymer fibers such as polyamide fibers, PET or PBT polyester fibers, phenol-formaldehyde (PF) fibers, polyvinyl alcohol fiber (PVOH) fibers, polyvinyl chloride fiber (PVC) fibers, polyolefins fibers, acrylic fibers, polyacrylonitrile fibers, aromatic polyamide (aramid) fibers, elastomeric fibers, polyurethane fibers, microfibers, and combinations thereof.

In one embodiment, the plurality of fibers (20) has a high modulus and high tensile strength. In another embodiment, the plurality of fibers (20) has a Young's modulus at 25 degrees Celsius (°C) of at least 3 gigapascals (GPa). For example, the plurality of fibers (20) may have a Young's modulus at 25°C of from 3 to 1,000 GPa, alternatively from 3 to 200 GPa, alternatively from 10 to 100 GPa. Moreover, the plurality of fibers (20) may have a tensile strength at 25°C of at least 50 MPa. For example, the plurality of fibers (20) may have a tensile strength at 25°C of from 50 to 10,000 megapascals (MPa), alternatively from 50 to 1,000 MPa, alternatively from 50 to 500 MPa.

The individual fibers are typically cylindrical in shape and may have a diameter of from 1 to 100 µm, alternatively from 1 to 20 (micrometers) µm, and alternatively form 1 to 10 µm. The plurality of fibers (20) may be heat-treated prior to use to remove organic contaminants. For example, the plurality of fibers (20) may be heated in air at an elevated temperature, for example, 575 °C, for a suitable period of time, for example 2 hours.

In one embodiment, the plurality of fibers (20) is further described as a mat or roving. In another embodiment, the plurality of fibers (20) is further described as a textile. The textile, or plurality of fibers, may be woven or non-woven or may include both woven and non-woven segments. In one embodiment, the textile is woven and is chosen from the group of fiberglass, polyester, polyethylene, polypropylene, nylon, and combinations thereof. In another embodiment, the textile is non-woven and is chosen from the group of fiberglass, polyester, polyethylene, polypropylene, nylon, and combinations thereof. In a further embodiment, the textile is non-woven fiberglass and is commercially available from Crane Nonwovens of Dalton, MA. Alternatively, the textile may be non-woven polyester commercially available from Crane Nonwovens. Further, the textile may be non-woven and include polypropylene or polyethylene terephthalate. The textile is not limited to aforementioned types of woven and non-woven textiles and may include any woven or non-woven textile known in the art. In one embodiment, more than one textile, e.g. two, three, or more individual textiles are utilized.

As is known in the art, woven textiles are typically cloths that are formed by weaving and that stretch in bias directions. As is also known in the art, non-woven textiles are neither woven nor knit and are typically manufactured by putting individual fibers together in the form of a sheet or web, and then binding them either mechanically, with an adhesive, or thermally by melting a binder onto the textile. Non-woven textiles may include staple non-woven textiles and spunlaid non-woven textiles. Staple non-woven textiles are typically made by spinning fibers that are spread in a uniform web and then bonded by using either resin or heat. Spunlaid non-woven textiles are typically made in one continuous process by spinning fibers directly disposed into a web. The spunlaid process can be combined with a meltblowing process to form a SMS (spun-melt-spun) non-woven textile.

Non-woven textiles may also include films and fibrillates and can be formed using serration or vacuum-forming to form patterned holes. Fiberglass non-woven textiles typically are one of two types including wet laid mats having wet-chopped, denier fibers having 6 to 20 micrometer diameters or flame attenuated mats having discontinuous denier fibers having 0.1 to 6 micrometer diameters. Non-limiting examples of suitable fibers are set forth in the Examples below.

The plurality of fibers (20) may be at least partially encapsulated by the backsheet (18). In various embodiments, at least 50, 75, or 95 percent of a total surface area of the plurality of fibers (20) is encapsulated by the backsheet (18), wherein the total surface area is at most 100 percent. In another embodiment, approximately 100 percent (e.g. from 99.5 to 100.0 percent) of a total surface area of the plurality of fibers (20) is encapsulated by the backsheet (18).

The terminology "encapsulated" refers to covering at least part of the surface area of the plurality of fibers (20). Typically, the backsheet (18), and/or a composition used to form the backsheet (18), covers and/or exudes through portions of the plurality of fibers (20) (e.g. the textile) such as pores. In an alternative embodiment, the plurality of fibers (20) is further described as being impregnated with the backsheet (18) and/or the composition used to form the backsheet (18). The backsheet (18) and/or the composition used to form the backsheet (18) may impregnate some or all of the plurality of fibers (20). That is, in this embodiment, the backsheet (18) and/or the composition used to form the backsheet (18) coats an exterior (surface area) of the plurality of fibers (20) and is also disposed throughout some or all of the voids described by the plurality of fibers (20). In other words, in this embodiment, the backsheet (18) and/or the composition used to form the backsheet (18) may exude through some voids and not through others. In a further embodiment, the plurality of fibers (20) is saturated with the composition used to form the backsheet (18). In another embodiment, the plurality of fibers (20) is not saturated with the composition used to form the backsheet (18). It is also contemplated that the backsheet (18) and/or the composition used to form the backsheet (18) may encapsulate the plurality of fibers (20) in whole or in part. The surface area of the plurality of fibers (20) may be at least partially encapsulated using any method known in the art including, but not limited to, spraying, dipping, rolling, brushing, and combinations thereof. In one embodiment, the plurality of fibers (20) is placed into the backsheet (18) and/or the composition used to form the backsheet (18). The backsheet (18) and/or the composition used to form the backsheet (18) may coat at least a part of the total surface area of the plurality of fibers (20) in a thickness 1 to 50, more typically of from 3 to 30, and most typically of from 4 to 15, mils. Of course, the disclosure is not limited to these thicknesses.

### Second Outermost Layer:

The module (26) also includes a second outermost layer (22). In one embodiment, this layer is described as an anti-soiling layer. Alternatively, the second outermost layer (22) may be described as a top coat layer (vis-à-vis the backsheet (18)). The second outermost layer (22) can be described as a bottom layer of the module (26), i.e., the layer of the module (26) disposed furthest away from the sun when the module (26) is disposed in front of the sun in use. The second outermost layer (22) is disposed opposite the first outermost layer (10) and is disposed on an outward facing surface of the backsheet (18) sandwiching the photovoltaic cell (14) and the backsheet (18) between the second outermost layer (22) and the first outermost layer (10). The second outermost layer (22) may be disposed on and in direct contact with the backsheet (18) or may be disposed on, but spaced apart from, the backsheet (18), e.g. a tie layer (24). In one embodiment, the second outermost layer (22) is disposed on but spaced apart from the backsheet (18) and the module (26) includes an intermediate layer, such as a tie layer (24), sandwiched between the second outermost layer (22) and the backsheet (18). One of the tie layers and/or encapsulants described below may function as the second outermost layer (22).

Typically, the second outermost layer (22) can be described as a bottom layer of the module (26), i.e., the layer of the module (26) disposed furthest away from the sun. The backsheet (18) and the second outermost layer (22) each have a thickness. In various embodiments, the thickness of the second outermost layer (22) is at least 0.5, 0.6, 0.7, 0.8, 0.9, 1, 1.1, 1.2, 1.3, 1.4, 1.5, 1.6, 1.7, 1.8, 1.9, or 2, microns, at one or more points along the second outermost layer (22). In various embodiments, the second outermost layer (22) will be present across a portion or all of the backsheet (18) in a thickness varying from 0.5 to 2 microns.

If the backsheet (18) includes fibers, the thickness of the second outermost layer (22) may be measured starting from the bottom of a trough in the fibers to a peak of the second outermost layer (22), as shown, for Example, in the SEM of Figure 21. Alternatively, if the backsheet (18) is free of fibers and/or substantially smooth, the thickness may be measured from a surface of the backsheet (18) to an upper surface of the second outermost layer (22). The thickness of the second outermost layer (22) may be measured by measuring a total thickness of the (backsheet (18) and the second outermost layer (22)) and subtracting a thickness of the backsheet (18) itself. Alternatively, thickness may be measured using SEM techniques and any appropriate ASTM test. For example, a sample may be mounted on an SEM stub and coated with 15 nm of Pt/Pd. The JEOL 6335 FE-SEM may be then set to 5 kv, 15 mm working distance, and an aperture of 4. SEM images may be captured between 25x and 500x magnification.

In still other embodiments, the second outermost layer (22) is present in a coating weight, i.e., in an amount in grams (g) relative to the surface area in square meters (m²) of the portion of the backsheet (18) in contact with the second outermost layer (22) of less than 75, 70, 65, 60, 55, 50, 45, 40, 35, 30, 25, 24, 23, 22, 21, 20, 19, 18, 17, 16, 15, 14, 13, 12, 11, 10, 9, 8, 7, 6, 5, 4, 3, 2, or 1, g/m². In further embodiments, the second outermost layer (22) is present in an amount of from 5 to 75, 10 to 70, 15 to 65, 20 to 60, 25 to 55, 30 to 50, 35 to 45, 40 to 45, 1 to 15, 2 to 14, 3 to 12, 4 to 11, 5 to 10, 6 to 9, or 7 to 8 g/m². Alternatively, the second outermost layer (22) may be generally described as having about 1 micron of thickness for about every 10 grams per meter squared of coating weight, as can be measured and appreciated by those of skill in the art, e.g. as measured by those methods described above.

The second outermost layer (22) may exhibit a coefficient of friction, as described above relative to the second outermost layer (22) of 0.1 to 0.7, 0.2 to 0.6, 0.3 to 0.5, 0.4 to 0.5, 0.1, 0.2, 0.3, 0.4, 0.5, 0.6, or 0.7, against itself measured according to ISO 8295. The terminology "against itself" describes that a material, e.g. the second outermost layer, is evaluated for coefficient of friction by rubbing a first sample of the material against a second sample of the identical material. Typically, the lower the coefficient of friction, the less dirt, soil, particulates are retained by (e.g. stuck to) the second outermost layer (22).

### Chemistry of the Backsheet and/or the Second Outermost Layer:

Both the backsheet (18) and the second outermost layer (22) may independently be, include, consist essentially of, or consist of a (or at least one) silicone (linear and/or branched polyorganosiloxanes), e.g. a first silicone and/or a second silicone. The terminology "consist essentially of" describes that the backsheet (18) and/or the second outermost layer (22) may be free of, or include less than 10, 5, 1, 0.1, 0.05, or 0.01, weight percent of, polymers, other than silicones, that would otherwise affect the physical properties of the silicone, as described above. Non-limiting examples of such polymers include organic polymers, Tedlar, poly(alkylenes), PET, plastics, and the like. In various embodiments, the backsheet (18) is, includes, consists essentially of, or consists of, a first silicone, i.e. linear and/or branched polyorganosiloxanes. In other embodiments, the second outermost layer (22) is, includes, consists essentially of, or consists of, a second silicone, i.e. linear and/or branched polyorganosiloxanes. Typically, the second silicone is different from the first silicone but they may be the same.

The silicone of the backsheet (18) and/or the second outermost layer (22) (e.g. the first silicone and/or the second silicone) may each independently be formed from a silicone composition that is cured, i.e. linear and/or branched polyorganosiloxanes that are cured. In one embodiment, the backsheet (18) is formed from a silicone composition that cures to form the backsheet (18). In another embodiment, the second outermost layer (22) is formed from a silicone composition that cures, i.e. linear and/or branched polyorganosiloxanes that cure, to form the second outermost layer (22). The silicone compositions used to form the backsheet (18) and/or the second outermost layer (22) may be the same or different from each other. Typically, they are different from each other. The chemistry (e.g. hydrosilylation, condensation or free-radical chemistry, and conditions used to cure the composition used to form the backsheet (18) may be the same or different from the cure chemistry and conditions, respectively, used to the cure the composition used to form the second outermost layer (22).

Either one or both silicone composition(s) may be independently any known in the art so long as the module (26) passes the Wet Leakage Current Test, as described above. Either one or both silicone composition(s) may independently include, but is not limited to, silanes, siloxanes, silazanes, silylenes, silyl radicals or ions, elemental silicon, silenes, silanols, polymers thereof, and combinations thereof. Typically, as used throughout, the terminology "silicone" may describe one or more linear and/or branched polyorganosiloxanes. In addition, either silicone composition may be cured, partially cured, or completely cured by any mechanism known in the art including, but not limited to, free radical reactions, hydrosilylation reactions, condensation or addition reactions, heat curing, UV curing, and combinations thereof. In various non-limiting embodiments, one or both of the first and second silicone compositions may be as described in U.S. App. Pub. No. 2011/0061724, which is expressly incorporated herein in its entirety relative to these non-limiting embodiments.

Either one or both silicone composition(s) may be further independently described as a curable silicone composition including, but are not limited to, hydrosilylation-curable silicone compositions, condensation-curable silicone compositions, and free-radical curable silicone compositions such as radiation-curable silicone compositions and light (e.g. UV light) curable compositions, and peroxide-curable silicone compositions.

A hydrosilylation-curable silicone composition typically includes an organopolysiloxane having an average of at least two silicon-bonded alkenyl groups or silicon-bonded hydrogen atoms per molecule; an organosilicon compound in an amount sufficient to cure the organopolysiloxane, wherein the organosilicon compound has an average of at least two silicon-bonded hydrogen atoms or silicon-bonded alkenyl groups per molecule capable of reacting with the silicon-bonded alkenyl groups or silicon-bonded hydrogen atoms in the organopolysiloxane; and a catalytic amount of a hydrosilylation catalyst.

A condensation-curable silicone composition typically includes an organopolysiloxane having an average of at least two silicon-bonded hydrogen atoms, hydroxy groups, or hydrolysable groups per molecule and, optionally, a cross-linking agent having silicon-bonded hydrolysable groups and/or a condensation catalyst.

A radiation-curable silicone composition typically includes an organopolysiloxane having an average of at least two silicon-bonded radiation-sensitive groups per molecule and, optionally, a cationic or free-radical photoinitiator depending on the nature of the radiation-sensitive groups in the organopolysiloxane.

A peroxide-curable silicone composition typically includes an organopolysiloxane having silicon-bonded unsaturated aliphatic hydrocarbon groups and an organic peroxide.

The silicone composition can be cured by exposing the composition to ambient temperature, elevated temperature, moisture, or radiation, depending on the type of curable silicone composition.

Hydrosilylation-curable silicone compositions can be cured by exposing the composition to a temperature of from room temperature (about 23 ± 2 °C) to 250 °C, alternatively from room temperature to 150 °C, alternatively from room temperature to 115 °C, at atmospheric pressure. The silicone composition is generally heated for a length of time sufficient to cure (cross-link) the organopolysiloxane. For example, the film is typically heated at a temperature of from 100 to 150 °C for a time of from 0.1 to 3 hours.

Condensation-curable silicone compositions cure depending on the nature of the silicon-bonded groups in the organopolysiloxane. For example, when the organopolysiloxane includes silicon-bonded hydroxy groups, the composition can be cured (i.e., cross-linked) by heating the composition. The composition can typically be cured by heating it at a temperature of from 50 to 250 °C, for a period of from 1 to 50 hours. When the condensation-curable silicone composition includes a condensation catalyst, the composition can typically be cured at a lower temperature, e.g., from room temperature (about 23 ± 2 °C) to 150 °C.

Condensation-curable silicone composition typically include an organopolysiloxane having silicon-bonded hydrogen atoms and can be cured by exposing the composition to moisture or oxygen at a temperature of from 100 to 450 °C for a period of from 0.1 to 20 hours. When the condensation-curable silicone composition includes a condensation catalyst, the composition can typically be cured at a lower temperature, e.g., from room temperature (about 23 ± 2 °C) to 400 °C.

Further, when the curable silicone composition is a condensation-curable silicone composition comprising an organopolysiloxane having silicon-bonded hydrolysable groups, the composition can be cured by exposing the composition to moisture at a temperature of from room temperature (about 23 ± 2 °C) to 250 °C, alternatively from 100 to 200 °C, for a period of from 1 to 100 hours. For example, the silicone composition can typically be cured by exposing it to a relative humidity of 30% at a temperature of from about room temperature (about 23 ± 2 °C) to 150 °C, for a period of from 0.5 to 72 hours. Cure can be accelerated by application of heat, exposure to high humidity, and/or addition of a condensation catalyst to the composition.

Radiation-curable silicone compositions can be cured by exposing the composition to an electron beam. Typically, the accelerating voltage is from about 0.1 to 100 kiloelectron volt (keV), the vacuum is from about 10 to 10⁻³ Pascals (Pa), the electron current is from about 0.0001 to 1 ampere, and the power varies from about 0.1 watt to 1 kilowatt. The dose is typically from about 100 microcoulombs per centimeter squared (microcoulomb/cm²) to 100 coulomb per centimeter squared (coulomb/cm²), alternatively from about 1 to 10 coulombs/cm². Depending on the voltage, the time of exposure is typically from about 10 seconds to 1 hour.

Also, when the radiation-curable silicone composition further includes a cationic or free radical photoinitiator, the composition can be cured by exposing it to radiation having a wavelength of from 150 to 800 nanometers (nm), alternatively from 200 to 400 nm, at a dosage sufficient to cure (cross-link) the organopolysiloxane. The light source is typically a medium pressure mercury-arc lamp. The dose of radiation is typically from 30 to 1,000 millijoules per centimeter squared (mJ/cm²), alternatively from 50 to 500 mJ/cm². Moreover, the silicone composition can be externally heated during or after exposure to radiation to enhance the rate and/or extent of cure.

When the curable silicone composition is a peroxide-curable silicone composition, the composition can be cured by exposing it to a temperature of from room temperature (about 23 ± 2 °C) to 180 °C, for a period of from 0.05 to 1 hours.

In one embodiment, the curable silicone composition, and/or the second outermost layer is, includes, consists essentially of, or consists of, the following reaction product of Parts A and B, e.g. in a 1:1 mixture by weight:

### Part A:

| | |
|---|---|
| 4.8 to 10 wt% | Dimethylvinylsiloxy-terminated Dimethyl, Methylvinyl Siloxane |
| 46 to 75 wt% | Dimethylvinyl terminated poly(dimethylsiloxane) |
| .007 to 1 wt% | 1,3-Diethenyl-1,1,3,3-tetramethyldisiloxane platinum complexes |
| 16 to 30 wt% | Dimethylvinylated and Trimethylated Silica |
| 0 to 30 wt% | Titanium Dioxide |

### Part B:

| | |
|---|---|
| .007 to 1 wt% | Ethynyl Cyclohexanol |
| .5 to 6 wt% | Trimethyl terminated poly(dimethylsiloxane) |
| 7 to 15 wt% | Trimethylsiloxy-terminated Dimethyl, Methylhydrogen Siloxane, |
| 6 to 12 wt% | Dimethylvinylsiloxy-terminated Dimethyl, Methlyvinyl Siloxane, |
| 37 to 60 wt% | Dimethylvinylsiloxy-terminated poly(dimethylsiloxane) |
| 16 to 30 wt% | Dimethylvinylated and Trimethylated Silica |
| 0 to 30 wt% | Titanium Dioxide |

Any of the aforementioned values may, for example, vary by 1, 2, 3, 4, 5, 10, 15, 20, or 25+ % in varying non-limiting embodiments. All values, and ranges of values, between and including the aforementioned values are also hereby expressly contemplated in various non-limiting embodiments.

In a further embodiment, the curable silicone composition and/or the second outermost layer is, includes, consists essentially of, or consists of, the following reaction product of Parts A and B in a 1:1 mixture by weight:

### Part A:

| | |
|---|---|
| 95.0 to 99.9 | Dimethyl Siloxane, Dimethylvinylsiloxy- terminated polymer |
| 0.1 to 0.3 | 1,3-Diethenyl-1,1,3,3-Tetramethyldisiloxane complexes (Platinum) |
| 0.5 to 3 | Methacryloxypropyltrimethoxysilane |

### Part B:

| | |
|---|---|
| 95.0 to 99.9 | Dimethyl Siloxane, Dimethylvinylsiloxy- terminated polymer |
| 1.0 to 3.0 | Dimethyl, Methylhydrogen Siloxane, trimethylsiloxy-terminated |
| 0.01 to 1 | Tetramethyltetravinylcyclotetrasiloxane |

Any of the aforementioned values may, for example, vary by 1, 2, 3, 4, 5, 10, 15, 20, or 25+ % in varying non-limiting embodiments. All values, and ranges of values, between and including the aforementioned values are also hereby expressly contemplated in various non-limiting embodiments.

In various non-limiting embodiments, the silicone of the second outermost layer (22) includes one or more components, compounds, systems, additives, catalysts, fillers as described in one or more of U.S. 6,354,620, 6,268,300, 2006/0276585, and/or JP 2010083946, each individually expressly incorporated herein by reference. In one embodiment, a flame resistant filler, or combination of fillers, is utilized which may allow the module to pass a Class A fire rating.

In one embodiment, the silicone of the second outermost layer (22) is formed from reacting
(A) a polyorganosiloxane having at least 2 silicon-bonded alkenyl groups per molecule and
(B) a polyorganohydrogensiloxane including at least 2 silicon-bonded hydrogen groups per molecule, in the presence of (C) a catalyst capable of promoting the reaction between (A) and (B).

The polyorganosiloxane (A) is typically a liquid and includes at least 2 alkenyl groups in each molecule. Each alkenyl group is typically independently a vinyl, allyl, methacryl, or hexenyl group. Non-alkenyl Si-bonded organic groups present in (A) may be alkyl groups such as methyl, ethyl, propyl, butyl, pentyl, isopropyl, isobutyl, cyclopentyl, and cyclohexyl groups; aryl groups such as phenyl and naphthyl groups; aralkyl groups such as benzyl and 1-phenylethyl groups; halogenated alkyl groups such as chloromethyl, 3-chloropropyl, 3,3,3-trifluoropropyl, and nonafluorobutylethyl groups; halogenated aryl groups such as 4-chlorophenyl, 3,5-dichlorophenyl, and 3,5-difluorophenyl groups; and aryl groups substituted by halogenated alkyl, such as 4-chloromethylphenyl and 4-trifluoromethylphenyl groups. The molecular structure of the polyorganosiloxane (A) is typically straight chain, but may include partial chain branching. Each of the at least two alkenyl groups may be bonded in terminal or pendant positions. The polyorganosiloxane (A) may be further defined as a dimethylvinylsiloxy-endblocked polydimethylsiloxane, dimethylvinylsiloxy-endblocked dimethylsiloxane-methylphenylsiloxane copolymers, dimethylvinylsiloxy-endblocked dimethylsiloxane-3,3,3-trifluoropropylmethylsiloxane copolymers, dimethylvinylsiloxy-endblocked dimethylsiloxane-methylvinylsiloxane copolymers, trimethylsiloxy-endblocked dimethylsiloxane-methylvinylsiloxane copolymers, or trimethylsiloxy-endblocked dimethylsiloxane-hexenylmethylsiloxane copolymers. Most typically, the dynamic viscosity of polyorganosiloxane (A) at 25°C is from 100 to 500,000, from 100,000 to 500,000, from 100,000 to 200,000, from 150,000 to 200,000, millipascal-seconds (mPa.s).

In one embodiment, (A) includes 10 to 50 mole % of vinylmethylsiloxane units based on a total number of moles of (A). In another embodiment, (A) includes both silicon-bonded vinyl groups and silicon-bonded hydroxyl groups in a single molecule. In still another embodiment, (A) includes both silicon-bonded vinyl groups and silicon-bonded hydroxyl groups in a single molecule.

The polyorganohydrogensiloxane (B) typically acts as a cross-linking agent in the presence of the catalyst (C). For example, hydrogen atoms bonded to silicon atoms of (B) may undergo an addition reaction with the alkenyl groups bonded of (A) resulting in cross-linking and cure. Typically, (B) includes at least two hydrogen atoms bonded to silicon atoms in each molecule. However, if there are only two alkenyl groups on (A), there are typically more than two silicon-bonded hydrogen groups on (B). Organic groups other than the hydrogen atoms bonded to silicon atoms which may be present in (B) include alkyl groups such as methyl groups, ethyl groups or propyl groups; aryl groups such as phenyl groups or tolyl groups; and substituted alkyl groups such as 3,3,3-trifluoropropylgroups or 3-chloropropyl groups.

The molecular structure of (B) may be linear or may include branching, cyclic or network forms. (B) may be further defined as a trimethylsiloxy-endblocked polymethydrogensiloxane, trimethylsiloxane-endblocked dimethylsiloxane-methylhydrogensiloxane copolymer, dimethylphenylsiloxy-endblocked methylphenylsiloxane-methylhydrogensiloxane copolymer, cyclic polymethylhydrogensiloxane, and copolymers composed of dimethylhydrogensiloxy and SiO_{4/2} units. Most typically, the dynamic viscosity of (B) at 25°C is from 3 to 10,000 mPa.s. Furthermore, the amount of (B) that is typically utilized is from 0.5:1 to 15:1 or from 1:1 to 10:1, as a ratio of the number of moles of hydrogen atoms bonded to silicon atoms (in (B)) to the number of moles of alkenyl groups bonded to silicon atoms (in (A)).

The catalyst (C) may be any substance that accelerates an addition reaction between (A) and (B) above. In various embodiments, (C) is a platinum compound, rhodium compound, and/or palladium compound, e.g. chloroplatinic acid, alcohol-modified chloroplatinic acid, chloroplatinic acid-olefin complexes, and diketonate complexes of platinum. (C) is typically utilized in amounts of from 0.1 to 1,000 parts per million (ppm), and typically 1 to 50 ppm platinum atoms, based on a weight of (A).

In other embodiments, the silicone of the second outermost layer (22) is formed from reaction of (I) an organopolysiloxane having a siloxane backbone of degree of polymerisation no more than 150 and being end-blocked with at least two silicon-bonded groups R, wherein R denotes an olefinically unsaturated hydrocarbon substituent, an alkoxy group or a hydroxyl group, and (II) a cross-linking organosilicon material having at least 3 silicon-bonded reactive groups, in the presence of (III) a catalyst and (IV) a filler. Notably, the (III) catalyst and the (IV) filler are typically different. In such an embodiment, the (IV) filler is then present in the silicone of the second outermost layer (22).

Typically, the (I) organopolysiloxane includes units of the general formula R¹ₐ R²_{b} SiO_{4-a-b/2}, wherein R¹ is a monovalent hydrocarbon group having up to 18 carbon atoms, R² is a monovalent hydrocarbon or hydrocarbonoxy group or a hydroxyl group, a and b have a value of from 0 to 3, and the sum of a+b is no more than 3. In one embodiment, (I) has the structure set forth below: 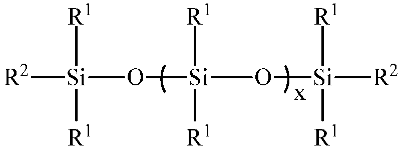 wherein R¹ and R² are described above and wherein x is an integer of no more than 148, typically having a value of from 5 to 100, more typically from 8 to 50. In various embodiments, R¹ is an alkyl or aryl group having from 1 to 8 carbon atoms, e.g. methyl, ethyl, propyl, isobutyl, hexyl, phenyl or octyl. In other embodiments, at least 50%, 75%, 90%, 95%, or about 100%, of all R¹ groups are methyl groups. In further embodiments, R² is selected from a hydroxyl group, an alkoxy group or an aliphatically unsaturated hydrocarbon group. Alternatively, R² may be a hydroxyl group or alkoxy group having up to 3 carbon atoms suitable for condensation reactions, or an alkenyl or alkynyl group having up to 6 carbon atoms, more typically vinyl, allyl or hexenyl, suitable for addition reactions.

In various embodiments, the organopolysiloxane polymer (I) has at least two silicon-bonded alkenyl groups per molecule and may have a dynamic viscosity of less than 500 mPas, or from 4 to 100 mPas, at 25°C. Alternatively, (I) can be, or can be mixed with, higher viscosity materials (e.g. greater than 100 mPa.s). In still other embodiments, (I) may be a homopolymer, copolymer or mixtures thereof which include units of the general formula R¹ₐR³_{c} SiO_{4-a-b/2} wherein R¹ and a are as described above, R³ is an alkenyl group having up to 8 carbon atoms and c is 0 or 1 provided that a+c is not greater than 3.

In still other embodiments, (I) can include at least one polymer containing vinylmethylsiloxane units, which can for example include from 0.5% or 1% by weight of the diorganosiloxane units of (A) up to 50 or even 100%. Mixtures of such vinylmethylsiloxane polymers can be used. For example, (I) in which 10 to 50 mole % of the siloxane units are vinylmethylsiloxane units can be used or (I) in which 1 to 10 mole % of the siloxane units are vinylmethylsiloxane units or a mixture can be used, or mixtures of both can be used. In various embodiments, (I) includes vinyldimethylsiloxy terminal groups and optionally other terminal groups such as trimethylsilyl.

In still other embodiments, (I) includes the following structure 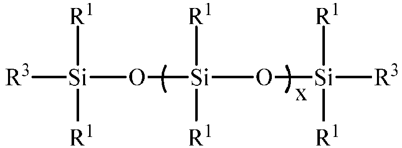 wherein R¹ is as described above, R³ is an alkenyl group having from 2 up to 8 carbon atoms, with the formula --R⁴_{y}-CH=CH₂, where R⁴ is a divalent hydrocarbon group having up to 6 carbon atoms, e.g. an alkylene group having up to 4 carbon atoms, y has a value of 0 or 1, and x has a value of from 5 to 100, 8 to 50, or 8 to 20. Alternatively, (I) can include a polysiloxane containing both silicon-bonded vinyl groups and silicon-bonded hydroxyl groups, for example a hydroxy-terminated poly(dimethyl, vinylmethyl siloxane).

Referring back to (II) the organosilicon compound, this compound is typically capable of reacting with (I) and may be a viscous or a free flowing liquid. Typically, (II) has a dynamic viscosity of less than 100 or about 2 to 55 mPas at 25°C. (II) may include one or more monomers, homopolymers, copolymers or mixtures thereof which include at least one unit of the general formula R¹ₐR⁵_{b}SiO_{4-a-b/2} wherein R¹, a and b are as above and R⁵ is a hydrogen atom, a hydroxyl or an alkoxy group, except that where (II) is a monomer (e.g. a silane) a+b would be 4 and b would be at least 3.

Typically, (II) is chosen from silanes, low molecular weight organosilicon resins and short chain organosiloxane polymers. (II) usually includes at least 3 silicon-bonded substituents R⁵ that are capable of reacting with the silicon-bonded group R² of (I). If R² is a hydroxyl or alkoxy group, the reactive substituents on (II) typically are either alkoxy groups or hydroxyl groups, allowing the condensation to take place between (I) and (II).

Suitable but non-limiting examples of (II) are alkyltrialkoxy silanes, e.g. methyltrimethoxy silane, ethyltrimethoxy silane, methyltriethoxy silane or methyltrihydrosilane, and combinations thereof, organosilicon resins including tetrafunctional siloxane units (Q units) of the formula SiO_{4/2} and monofunctional units (M units), short chain organosiloxane polymers such as short chain polyorganosiloxanes having at least 3 silicon-bonded alkoxy, hydroxyl or hydrogen atoms per molecule, e.g. trimethyl siloxane end-blocked polymethylhydrosiloxane having up to 20 carbon atoms, tetramethylcyclotetrasiloxane and silanol end-blocked dimethylsiloxane-methylsilanol copolymers, and combinations thereof.

In still other embodiments, (II) is a short chain polyorganosiloxane having at least 3 silicon-bonded hydrogen atoms, typically having a silicon-bonded hydrogen atom on at least 40% of, more typically on the majority of silicon atoms in the molecule. In one embodiment, (II) is a substantially linear or cyclic compound. In other embodiments, (II) has the formula R⁷R⁶₂SiO(R⁶₂SiO)ₚ(R⁶HSiO)_{q}SiR⁶₂R⁷ or 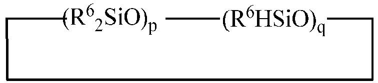 wherein R⁶ is an alkyl or aryl group having up to 10 carbon atoms, R⁷ is R⁶ or a hydrogen atom, p has a value of from 0 to 20, q has a value of from 1 to 70, and there are at least 3 silicon-bonded hydrogen atoms present per molecule. In one embodiment, R⁶ is a lower alkyl group having no more than 3 carbon atoms, e.g. a methyl group, and R⁷ is R⁶ provided at least 3 of the R⁷ are hydrogen atoms. Typically, p and q have similar values or p=0 and q has a value of from 6 to 70, more typically 20 to 60, or where cyclic organosilicon materials are used, from 3 to 8.

Referring now to (III), the catalyst (III) may be any compound which catalyses the reaction between (I) and (II) above. Where the reaction is a condensation reaction, the catalyst may be any of the known condensation catalysts, e.g. acids, including sulphuric acid, hydrochloric acid, Lewis acids, bases, e.g. sodium hydroxide, potassium hydroxide, tetramethylammonium hydroxide, tetrabutylphosphonium silanolate and amines, catalysts based on tin or titanium, e.g. dialkyltin dicarboxylic acids and tetraalkyl titanates. Particularly useful organotitanium compounds have organic groups attached to titanium through a titanium-oxygen-carbon linkage. The main types are ortho-esters, i.e. alcoholates and acylates in which the organic group is derived from a carboxylic acid. An organotitanium catalyst may also contain both types of the aforementioned groups attached to the same titanium atom. Operative organotitanium catalysts thus include those of the formula Ti(OR⁸)₄ wherein R⁸ is alkyl, alkoxyalkyl or acyl, for example tetraisopropyl titanate, tetramethoxy-ethoxytitanate and diisopropyl diacetoxytitanate. The preferred organotitanium catalysts for use in this invention are the chelated or partially chelated titanium compounds. These materials are produced, for example by reacting an alcoholate as referred to above with an alpha- or beta-diketone or a derivative thereof.

Additional suitable catalysts (III) include Group VIII metal-based or noble metal catalysts e.g. rhodium, ruthenium, palladium, osmium, iridium or platinum containing catalysts. Platinum-based catalysts are particularly preferred and may take any of the known forms, ranging from platinum deposited onto carriers, for example powdered charcoal, to platinic chloride, salts of platinum, chloroplatinic acids and encapsulated forms thereof. A preferred form of platinum catalyst is chloroplatinic acid, platinum acetylacetonate, complexes of platinous halides with unsaturated compounds such as ethylene, propylene, organovinylsiloxanes, and styrene, hexamethyldiplatinum, PtCl₂, PtCl₃, PtCl₄, and Pt (CN)₃.

In even further embodiments, the silicone of the second outermost layer (22) is formed from reacting (i, ii) addition-crosslinking organosilicon compounds in the presence of a (iii) catalyst. Referring to (i), this compound is typically an organosilicon compound that is linear, cyclic or branched, e.g. a siloxane that may include units of the formula R²ₛR³ₜSiO_{(4-s-t)/2} where R² in each occurrence may be the same or different and is an SiC bonded aliphatically unsaturated hydrocarbyl radical, R³ in each occurrence may be the same or different and is an optionally substituted SiC-bonded aliphatically saturated hydrocarbyl radical, s is 0, 1, 2 or 3, typically 0, 1 or 2, and t is 0, 1, 2 or 3, with the proviso that the sum total s+t is not more than 3 and two or more R² radicals are present per molecule. In various embodiments, R² represents hydrocarbyl radicals of 2 to 18 carbon atoms having aliphatic multiple bonding, such as vinyl, allyl, methallyl, 2-propenyl, 3-butenyl, 4-pentenyl, 5-hexenyl, butadienyl, hexadienyl, cyclopentenyl, cyclopentadienyl, cyclohexenyl, ethynyl, propargyl and 2-propynyl, this kind of R.sup.2 radical with 2 to 6 carbon atoms being particularly preferred, especially vinyl and allyl. In other embodiments, R³ represents optionally substituted aliphatically saturated monovalent hydrocarbyl radicals having 1 to 18 carbon atoms, more typically having 1 to 8 carbon atoms, especially methyl. Additional examples of R³ are alkyl radicals such as the methyl, ethyl, n-propyl, isopropyl, 1-n-butyl, 2-n-butyl, isobutyl, tert-butyl, n-pentyl, isopentyl, neopentyl, and tert-pentyl radicals; hexyl radicals such as n-hexyl; heptyl radicals such as n-heptyl; octyl radicals such as n-octyl and isooctyl such as 2,2,4-trimethylpentyl; nonyl radicals such as n-nonyl; decyl radicals such as n-decyl; dodecyl radicals such as n-dodecyl; octadecyl radicals such as n-octadecyl; cycloalkyl radicals such as cyclopentyl, cyclohexyl, cycloheptyl and methylcyclohexyl radicals; alkenyl radicals such as vinyl, 1-propenyl and 2-propenyl radicals; aryl radicals such as phenyl, naphthyl, anthryl and phenanthryl; alkaryl radicals such as o-, -, p-tolyl radicals, xylyl radicals and ethylphenyl radicals; and aralkyl radicals such as the benzyl, alpha-phenylethyl and beta-phenylethyl radicals.

Referring now to (ii), organosilicon compounds having Si-bonded hydrogen atoms are typically linear, cyclic or branched siloxanes consisting of units of the formula R⁴ᵤHᵥSiO_{(4-u-v)/2} where R⁴ in each occurrence may be the same or different and may be the same as R³, u is 0, 1, 2 or 3, and v is 0, 1 or 2, typically 0 or 1, with the proviso that the sum total of u+v is not more than 3 and there are on average two or more Si-bonded hydrogen atoms per molecule.

In various embodiments, (ii) includes three or more SiH bonds per molecule. In other embodiment wherein (ii) only has two SiH bonds per molecule, (i) typically includes at least three aliphatic carbon-carbon multiple bonds per molecule. In still other embodiments, (ii) has an Si-bonded hydrogen content of typically 0.002% to 1.7% by weight of hydrogen and more typically between 0.1% and 1.7% by weight of hydrogen. In other embodiments, (ii) is present in an amount relative to (i) such that the molar ratio of SiH groups in (ii) to radicals having aliphatic carbon-carbon multiple bonding of (i) is between 0.5 and 5 and more typically between 1.0 and 3.0.

In any embodiment above, one or more fillers may be used. One or more fillers may be hydrophilic or hydrophobic and may include reinforcing fillers, non-reinforcing fillers, and/or combinations thereof. In one embodiment, a reinforcing filler is utilized. Non-limiting examples of reinforcing fillers include silica, titanium dioxide, ground quartz, calcium carbonate, alumino silicates, organosilicon resins. Fumed or precipitated silica fillers may also be used. Non-limiting examples of non-reinforcing fillers which can be employed are quartz flour, calcium silicate, zirconium silicate, zeolites, metal oxide powders, such as aluminum oxide, titanium oxide, iron oxide or zinc oxide, barium silicate, calcium carbonate and if appropriate calcium sulfate and barium sulfate when an inhibiting effect can be ruled out, and also polymeric powders, such as polyacrylonitrile powder or polytetrafluoroethylene powder. Additional fillers further include fibrous components, such as glass fibers and polymeric fibers.

In other embodiments, the filler is described as an oval or sphere-shaped solid and/or a laminar solid, which may be the same or different from one another. Suitable non-limiting spherical-oval solids may be selected from the group of the silicon oxides and metal oxides, organic compounds, organosilicon compounds, and combinations thereof. Oxides of the metals aluminum, titanium, zirconium, tantalum, tungsten, hafnium, zinc, and tin may be used. Colloidal silicas and precipitated silicas may also be used. Aluminas such as corundum, mixed aluminum oxides with other metals and/or silicon, titanias, zirconias, and iron oxides can also be used. Spherical fillers may have a diameter in from 0.01 to 100, from 1 to 40, or from 2 to 25 µm.

The filler may include thin-walled hollow spheres or microcapsules providing the option of taking up a fluid, multilayered walling structures, core-shell structures, thick-walled hollow spheres or solid spheres having particle sizes in the nanometer or micrometer range, or combinations thereof. The filler may be inorganic, xenomorphous, hypidiomorphous, microcrystalline, cristallite like X-ray amorphous to amorphous or include mixed forms of different intergrowths/aggregations, and may be not only monophasic but also polyphasic. Spheres, microspheres or nanospheres of borosilicate glass, technical grade glass, SiO₂ glass, calcium carbonate or ceramic compositions, may also be utilized. The filler may be treated with functional silanes such as vinyltrialkoxysilanes, vinyltriacetoxysilanes, glycidoxypropyltrialkoxysilanes or methacryloyloxypropyltrialkoxysilanes. Non-limiting examples of additional organofunctional groups include acryloyl groups, epoxy groups, hydroxyl groups, and alkoxy groups.

Alternatively, polymeric organic particles or powders having particle sizes in the nanometer to micrometer range or mixtures thereof, such as vinyl acetate-ethylene copolymers, polyacrylonitrile powders, acrylates or styrene-acrylates, may be utilized. Spherical solid silicone resins, such as MQ resins, TD resins having glass transition points of around 30°C and/or silicone elastomers, which may also include functional groups, may also be used.

The filler may also include laminar solids selected from natural phyllosilicates such as mica or clay minerals including calcined variants, synthetic solids such as metal or glass flakes or platelet-shaped metal oxides/hydroxides or tectosilicates such as leaf zeolites, or combinations thereof. Non-limiting examples of natural phyllosilicates are three-layer silicates of the talc pyrophyllite group, the di- to trioctahedral three-layer silicates of the mica group such as muscovite, paragonite, phlogopite, and biotite, the four-layer silicates of the chlorite group and representatives of the clay mineral group, such as kaolinite, montmorillonite, and illite.

Laminar fillers may be partly untreated or surface treated with functional silanes, whereby a slight reinforcing effect can be achieved. Non-limiting examples of functional silanes with which the fillers can be surface treated are vinyltrialkoxysilanes, vinyltriacetoxysilanes, glycidoxypropyltrialkoxysilanes or methacryloyloxypropyltrialkoxysilanes. Mono-, di- and tetraalkoxysilanes, which may bear organic functions in addition to the alkoxy function, may also be utilized.

Laminar solids, given sufficient delamination, are typically characterized in that their length is numerically greater than their thickness. Depending on whether they are natural sheet-silicates or the preferably calcined variants, the thickness is typically 10 to 20 times smaller than the length.

The filler may alternatively include a reinforcing filler combined with the laminar solid that has a high specific surface area >50 square meters per gram of the laminar solid (m²/g) or a high oil number >100. The filler may also include diverse nanoscale components such as aluminosilicates, calcium carbonate, and silicon dioxide. Non-limiting examples of reinforcing fillers are pyrogenic or precipitated silicas having Brunaur-Emmett-Teller (BET) surface areas of at least 50 m²/g, furnace black and acetylene black. Non-limiting examples of reinforcing solids possessing high oil absorption are diatomaceous earths, which can be used in calcined or preferably in natural form. The laminar and an additionally reinforcing solid can be present in weight ratios of 2:1 and 1:2, or in a ratio of 1:1, compared to one another.

In other embodiments, the surface of the filler is rendered hydrophobic to make the filler more compatible with the aforementioned components. Rendering the filler hydrophobic may be done either prior to or after dispersing the filler in, for example, (A), (I), or (i). This can be effected by pre-treatment of the filler with fatty acids, reactive silanes or reactive siloxanes. Non-limiting examples of suitable hydrophobing agents include stearic acid, dimethyldichlorosilane, divinyltetramethyl disilazane, trimethylchlorosilane, hexamethyldisilazane, hydroxyl end-blocked or methyl end-blocked polydimethylsiloxanes, siloxane resins or mixtures of two or more of these. Alternatively, the surface of the filler may be rendered hydrophobic in situ, that is, after the filler has been dispersed. Silicone resins may also be used as a filler, for example an MQ resin.

In one embodiment, (A), (I), and/or (i) and (B), (II), and/or (ii) are reacted in the presence of a filler chosen from a metallic filler, an inorganic filler, a meltable filler, and combinations thereof and wherein the filler is present in the product of a reaction between (A), (I), and/or (i) and (B), (II), and/or (ii), e.g. in the second outermost layer (22). In such an embodiment, the filler would then be present in the module and/or the second outermost layer (22). Alternatively, (A), (I), and/or (i) and (B), (II), and/or (ii) may be reacted in the presence of talc in an amount of from 2 to 70 weight percent based on a total weight of the second outermost layer (22). In another embodiment, (A), (I), and/or (i) and (B), (II), and/or (ii) are reacted together in the presence of titanium dioxide in an amount of up to about 30 or 35 weight percent based on a total weight of the second outermost layer (22) wherein a total amount of titanium dioxide and optionally talc does not exceed about 45 weight percent. Throughout this disclosure, the combinations of components may describe both physical combinations of components and/or functional combinations of components. The "weight" of the second outermost layer (22) can be determined
by weighing all other components of the module before addition of the second outermost layer (22) and then again after addition and determining the difference there between. Alternatively, the weight of the second outermost layer (22) may be determined by weighing the components of the second outermost layer (22) immediately prior to addition to one or more components of the module described above. For example, if the second outermost layer (22) is formed from a composition, the weight of the composition may be utilized to determine the weight of the second outermost layer (22) and may provide a basis for weights of one or more of the aforementioned components, compounds, or fillers, and the like.

In various other embodiments, the second outermost layer (22) may be described as being, including, consisting essentially of, or consisting of Wacker Elastosil^{®} 47007 and/or Shinetsu X-32-2988 / CX-32-2988 coatings that may include kaolin, ethyl silicate and quartz as fillers. The terminology "consisting essentially of" may describe that, in this embodiment, the second outermost layer (22) is free of additional polymers, such as polyorganosiloxanes and/or organic polymers.

In another embodiment, the second outermost layer is, includes, consists essentially of, consists of, or is formed from, the following composition wherein the ratio of the Base to Curing Agent parts is is 1:3, 2:3, 3:3, 4:3, 5:3, 6:3, 7:3, 8:3, 9:3, or 10:3:

### Base:

| | |
|---|---|
| 3 to 10 wt % | alpha-Hydroxy-, omega-Methoxy-terminated Dimethyl, Methylvinyl Siloxane |
| 15 to 30 wt % | Hydroxy-terminated Dimethyl, Methylvinyl Siloxane |
| 7 to 15 wt % | Trimethyl terminated dimethyl, methylvinyl siloxane |
| 8 to 15 wt% | Dimethylvinylsiloxy-terminated Dimethyl, Methylvinyl Siloxane |
| 0.1 to 1 wt % | Dimethylcyclosiloxanes |
| 40 to 60 wt % | Talc Magnesium Silicate |
| .007 to 1 wt% | 1,3-Diethenyl-1,1,3,3,-tetramethyldisiloxane platinum complexes |

### Curing Agent:

| | |
|---|---|
| 0.1 to 1 wt% | Ethynyl Cyclohexanol |
| 95 to 98 wt% | Hydroxy terminated poly(dimethylsiloxane) |
| 2 to 5 wt% | Dimethylvinylsiloxy-terminated Dimethyl, Methylvinyl Siloxane |

### Additives:

Any one of the aforementioned compositions or components may also include one or more additives. In one embodiment, dyes, adhesion promoters, colorants, pigments, bath-life extenders and flexibilizers, cure inhibitors, flame retardants, antioxidants and/or catalyst boosters are utilized. Other suitable additives are those that e.g. enhance the efficiency of an adhesion-promoting additive, e.g. a metal chelate compound such as acetyl acetonates e.g. triacetylacetonates of aluminium, tetra acetylacetonates of zirconium and triacetylacetonates of iron. Aluminium chelates are preferred, especially aluminium acetyl-acetonate.

Alternatively, natural drying oils and modified natural drying oils, liquid diene compounds, and/or unsaturated fatty acid esters may be utilized. Non-limiting examples include the natural dying oils, such as tung oil, linseed oil, vernonia oil, and oiticica oil; and modified natural drying oils such as boiled linseed oil and dehydrated castor oil; liquid diene compounds such as 1,3-hexadiene or polybutadiene, and fatty acid esters which are unsaturated, and may have more than 10 carbon atoms. Additives such as these may be utilized in amounts of from about 0.1 to 5 weight percent based on the total weight of the composition.

In still other embodiments, resinous polyorganosiloxanes, dispersing assistants, solvents, viscosity modifiers, adhesion promoters, pigments, dyes, plasticizers, organic polymers, thermostabilizers, inhibitors and stabilizer may be utilized. Non-limiting examples of inhibitors include acetylenic alcohols, such as 1-ethynyl-1-cyclohexanol, 2 methyl-3-butyn-2-ol and 3,5-dimethyl-1-hexyn-3-ol, 3-methyl-1-dodecyn-3-ol, polymethylvinylcyclosiloxanes, such as 1,3,5,7-tetravinyltetramethyltetracyclosiloxane, tetravinyldimethyldisiloxane, trialkyl cyanurates, alkyl maleates, such as diallyl maleates, dimethyl maleate and diethyl maleate, alkyl fumarates, such as diallyl fumarate and diethyl fumarate, organic hydroperoxides, such as cumene hydroperoxide, tert-butyl hydroperoxide and pinane hydroperoxide, organic peroxides, organic sulfoxides, organic amines, diamines and amides, phosphines and phosphites, nitriles, triazoles, diaziridines and oximes. Non-limiting examples of adhesion promoters are epoxysilanes, methacryloyloxysilanes or polysiloxanes. Non-limiting examples of thermostabilizers are transition metal fatty acid salts, such as iron octoate, transition metal silanolates, such as iron silanolate, and also cerium(IV) compounds. Water and solvents such as, for example, toluene, xylene, benzines and ethyl acetate, can also be used. The compositions can be dissolved, dispersed, suspended or emulsified in liquids such as solvent or water.

### Tie Layer(s)/Encapsulant(s):

The photovoltaic cell (14) module (26) may also include one or more tie layers (24) and/or encapsulants. A tie layer (24) may function to adhere one or more of the aforementioned layers to one another and may also act as an encapsulant. In one embodiment, the module (26) includes a first encapsulant (12) and a second encapsulant (16) surrounding the photovoltaic cell (14). One or more encapsulants may also surround any one or more components of the module (26) described above. Various non-limiting embodiments are set forth in the Figures. In one embodiment, the module (26) includes an encapsulant disposed on and in direct contact with the front side and the back side of the photovoltaic cell (14).

The tie layer(s) (24)/encapsulant(s) (12,16) typically are, include, consist essentially of, or consist of, one or more silicones which may be the same or different from any other silicone described herein. The terminology "consist essentially of" typically describes that the tie layer(s) (24)/encapsulant(s) (12,16) are free of non-silicone polymers, e.g. organic polymers. In various embodiments, one or more tie layer(s) (24)/encapsulant(s) (12,16) may independently include, but are not limited to, silanes, siloxanes, silazanes, silylenes, silyl radicals or ions, elemental silicon, silenes, silanols, polymers thereof, and combinations thereof. In addition, one or more tie layer(s) (24)/encapsulant(s) may be curable, cured, partially cured, or completely cured by any mechanism known in the art including, but not limited to, free radical reactions, hydrosilylation reactions, condensation or addition reactions, heat curing, UV curing, and combinations thereof.

The tie layer(s) (24)/encapsulant(s) (12,16) may be disposed between any two or more layers of the module (26). The tie layer(s) (24)/encapsulant(s) (12,16) may have a depth of penetration (value) of from 1.1 to 100 mm. The terminology "depth of penetration" is also referred to as "penetration" or "penetration value." In various embodiments, the tie layer(s) (24)/encapsulant(s) (12,16) has a depth of penetration of from 1.3 to 100 mm and more typically of from 2 to 55 mm. Without intending to be bound by any particular theory, it is believed that as temperature rises, the depth of penetration values also rise. It is contemplated that the tie layer(s) (24)/encapsulant(s) (12,16) may have a depth of penetration of from 1.1 to 100 mm, of from 1.3 to 100 mm, or of from 2 to 55 mm, as determined at room temperature or at any other temperature. Typically, depth of penetration is determined at room temperature and using the procedure described in U.S. App. Pub. No. 2011/0061724, expressly incorporated herein by reference.

The tie layer(s) (24)/encapsulant(s) (12,16) may also have a tack value of less than - 0.6 g.sec. In various embodiments, the tie layer(s) (24)/encapsulant(s) (12,16) has a tack value of from -0.7 to -300 g.sec and more typically of from -1 to -100 g.sec. In one embodiment, the tie layer(s) (24)/encapsulant(s) (12,16) has a tack value of about -27 g.sec. The tack value is determined using the procedure described in U.S. App. Pub. No. 2011/0061724, expressly incorporated herein by reference.

The tie layer(s) (24)/encapsulant(s) (12,16) may be tacky and may be a gel, gum, liquid, paste, resin, or solid. In one embodiment, the tie layer(s) (24)/encapsulant(s) (12,16) is a film. In another embodiment, the tie layer(s) (24)/encapsulant(s) (12,16) is a gel. In yet another embodiment, the tie layer(s) (24)/encapsulant(s) (12,16) is a liquid that is cured (e.g. pre-cured) to form a gel. Alternatively, the tie layer(s) (24)/encapsulant(s) (12,16) may include multiple segments, with each segment including a different composition and/or different form (e.g., gel and liquid), so long as the segments and the overall tie layer(s) (24)/encapsulant(s) (12,16) have the appropriate depth of penetration and tack values, set forth above. Examples of suitable compositions for use as the tie layer(s) (24)/encapsulant(s) are described in U.S. App. Pub. No. 2011/0061724 and/or U.S. Pat. Nos. 5,145,933, 4,340,709, and 6,020,409, each of which is expressly incorporated herein by reference relative to these compositions.

The tie layer(s) (24)/encapsulant(s) (12,16) may be formed from and/or include any suitable compound known in the art. These compounds may or may not require curing. In one embodiment, the curable composition includes at least one of an ethylene-vinyl acetate copolymer, a polyurethane, an ethylene tetrafluoroethylene, a polyvinylfluoride, a polyethylene terephthalate, and combinations thereof. In another embodiment, the curable composition includes carbon atoms and is substantially free of compounds including silicon atoms. The terminology "substantially free," as used immediately above, refers to less than 0.1 weight percent of compounds including silicon atoms present in the curable composition. The curable composition may include organic compounds and less than 0.1 weight percent of compounds including silicon atoms.

In a further embodiment, the tie layer(s) (24)/encapsulant(s) (12,16) is formed from a curable composition including silicon atoms. The tie layer(s) (24)/encapsulant(s) (12,16) may be formed completely from a curable silicone composition such as those disclosed in U.S. Pat. Nos. 6,020,409 and 6,169,155, herein expressly incorporated by reference relative to these curable silicone compositions. In an alternative embodiment, the tie layer(s) (24)/encapsulant(s) (12,16) may be formed from a cured or curable composition that includes a silicone fluid such as those commercially available from Dow Corning Corporation of Midland, MI. One non-limiting example of a particularly suitable silicone fluid is trimethylsilyl terminated polydimethylsiloxane having a dynamic viscosity of 100 mPa.s at 25°C.

In one embodiment, the curable silicone composition is further defined as hydrosilylation-curable and includes an organosilicon compound having at least one unsaturated moiety per molecule, an organohydrogensilicon compound having at least one silicon-bonded hydrogen atom per molecule, and a hydrosilylation catalyst used to accelerate a hydrosilylation reaction between the organosilicon compound and the organohydrogensilicon compound. In this embodiment, a ratio of silicon-bonded hydrogen atoms per molecule of the organohydrogensilicon compound to unsaturated moieties per molecule of the organosilicon compound is typically of from 0.05 to 100.

In an alternative embodiment, the organosilicon compound is further defined as an alkenyldialkylsilyl end-blocked polydialkylsiloxane which may itself be further defined as vinyldimethylsilyl end-blocked polydimethylsiloxane. The organohydrogensilicon compound may also be further defined as a mixture of a dialkylhydrogensilyl terminated polydialkylsiloxane and a trialkylsilyl terminated polydialkylsiloxane - alkylhydrogensiloxane co-polymer. The dialkylhydrogensilyl terminated polydialkylsiloxane itself may be further defined as dimethylhydrogensilyl terminated polydimethylsiloxane while the trialkylsilyl terminated polydialkylsiloxane - alkylhydrogensiloxane co-polymer may be further defined as a trimethylsilyl terminated polydimethylsiloxane - methylhydrogensiloxane co-polymer. Alternatively, the tie layer(s) (24)/encapsulant(s) (12,16) may be formed from a curable composition including one or more of components (A)-(E) and combinations thereof, as described in U.S. App. Pub. No. 2011/0061724, expressly incorporated herein by reference relative to these components.

### Additional Embodiments of the Module:

In one additional embodiment, the first encapsulant is disposed on and in direct contact with the first outermost layer, the textile is disposed within the first encapsulant, the photovoltaic cell is disposed on and in direct contact with the first encapsulant, the second encapsulant is disposed on and in direct contact with both the photovoltaic cell and the first encapsulant, the backsheet is disposed on and in direct contact with the second encapsulant, and the second Outermost layer is disposed on and in direct contact with the backsheet.

In another additional embodiment, the photovoltaic cell module includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the textile disposed within both the first encapsulant and the second encapsulant, the backsheet disposed on and in direct contact with the second encapsulant, and the second outermost layer disposed on and in direct contact with the backsheet.

In still another additional embodiment, the photovoltaic cell module includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer disposed on and in direct contact with the second encapsulant, the backsheet disposed on and in direct contact with the tie layer, the textile disposed within both the second encapsulant and the backsheet, and the second outermost layer disposed on and in direct contact with the backsheet.

In a further additional embodiment, the photovoltaic cell module includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer disposed on and in direct contact with the second encapsulant, the backsheet disposed on and in direct contact with the tie layer, the textile disposed within both the first encapsulant and the backsheet, and the second outermost layer disposed on and in direct contact with the backsheet.

In another additional embodiment, the photovoltaic cell module includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer disposed on and in direct contact with the second encapsulant, the backsheet disposed on and in direct contact with the tie layer, the textile disposed within all the first encapsulant, the tie layer and the backsheet, and the second outermost layer disposed on and in direct contact with the backsheet.

In still another additional embodiment, the photovoltaic cell module includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer disposed on and in direct contact with the second encapsulant, the backsheet disposed on and in direct contact with the tie layer, the textile disposed within all the first encapsulant, the second encapsulant and the backsheet, and the second outermost layer disposed on and in direct contact with the backsheet.

In yet another additional embodiment, the photovoltaic cell module includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer disposed on and in direct contact with the second encapsulant, the backsheet disposed on and in direct contact with the tie layer, the textile disposed within all the first encapsulant, the second encapsulant, the tie layer and the backsheet, and the second outermost layer disposed on and in direct contact with the backsheet.

In an additional embodiment, the photovoltaic cell module includes the first outermost layer, the first encapsulant disposed on and in direct contact with the first outermost layer, the photovoltaic cell disposed on and in direct contact with the first encapsulant, the textile disposed within the first encapsulant, the second encapsulant disposed on and in direct contact with both the photovoltaic cell and the first encapsulant, the tie layer disposed on and in direct contact with the second encapsulant, the backsheet disposed on and in direct contact with the tie layer, and the second outermost layer disposed on and in direct contact with the backsheet.

In another additional embodiment, the photovoltaic cell module includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer disposed on and in direct contact with the second encapsulant, the textile disposed within both the first encapsulant and the tie layer, the backsheet disposed on and in direct contact with the tie layer, and the second outermost layer disposed on and in direct contact with the backsheet.

In a further additional embodiment, the photovoltaic cell module includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the textile disposed within both the first encapsulant and the second encapsulant, the tie layer disposed on and in direct contact with the second encapsulant, the backsheet disposed on and in direct contact with the tie layer, and the second outermost layer disposed on and in direct contact with the backsheet.

In another additional embodiment, the photovoltaic cell module includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer disposed on and in direct contact with the second encapsulant, the textile disposed within all the first encapsulant, the second encapsulant and the tie layer, the backsheet disposed on and in direct contact with the tie layer, and the second outermost layer disposed on and in direct contact with the backsheet.

In still a further additional embodiment, the photovoltaic cell module includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer disposed on and in direct contact with the second encapsulant, the textile disposed within both the first encapsulant and the tie layer, and the second outermost layer disposed on and in direct contact with the tie layer.

In another embodiment, the photovoltaic cell module includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer, functioning as the backsheet, disposed on and in direct contact with the second encapsulant, the textile disposed within all the first encapsulant, the second encapsulant and the tie layer, and the second outermost layer disposed on and in direct contact with the tie layer.

In another additional embodiment, the photovoltaic cell module includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer, functioning as the backsheet, disposed on and in direct contact with the second encapsulant, the textile disposed within the first encapsulant and on and in direct contact with both the second encapsulant and the tie layer, and the second outermost layer disposed on and in direct contact with the tie layer.

In still another additional embodiment, the photovoltaic cell module includes the first outermost layer, the first encapsulant disposed on and in direct contact with the first outermost layer, the photovoltaic cell disposed on and in direct contact with the first encapsulant, the textile disposed within the first encapsulant, the second encapsulant disposed on and in direct contact with both the photovoltaic cell and the first encapsulant, the tie layer, functioning as the backsheet, disposed on and in direct contact with the second encapsulant, and the second outermost layer disposed on and in direct contact with the tie layer.

In a further additional embodiment, the photovoltaic cell module includes the first outermost layer, the first encapsulant disposed on and in direct contact with the first outermost layer, the photovoltaic cell disposed on and in direct contact with the first encapsulant, the second encapsulant disposed on and in direct contact with both the photovoltaic cell and the first encapsulant, the tie layer, functioning as the backsheet, disposed on and in direct contact with the second encapsulant, the textile disposed within both the first encapsulant and the second encapsulant, and the second outermost layer disposed on and in direct contact with the tie layer.

In another additional embodiment, the photovoltaic cell module includes the first outermost layer, the first encapsulant disposed on and in direct contact with the first outermost layer, the photovoltaic cell disposed on and in direct contact with the first encapsulant, the second encapsulant, functioning as the backsheet, disposed on and in direct contact with both the photovoltaic cell and the first encapsulant, the textile disposed within both the first encapsulant and the second encapsulant, and the second outermost layer disposed on and in direct contact with the second encapsulant.

In another additional embodiment, the photovoltaic cell module includes the first outermost layer, the first encapsulant disposed on and in direct contact with the first outermost layer, the photovoltaic cell disposed on and in direct contact with the first encapsulant, the textile disposed within the first encapsulant, the second encapsulant, functioning as the backsheet, disposed on and in direct contact with both the photovoltaic cell and the first encapsulant, and the second outermost layer disposed on and in direct contact with the second encapsulant.

### Method of Forming the Photovoltaic Cell Module:

The present disclosure also provides a method of forming the module (26). The method includes the step of assembling the first outermost layer (10), the photovoltaic cell (14), the backsheet (18), and the second outermost layer (22) to form the module (26). In one embodiment, the first outermost layer (10), the photovoltaic cell (14), and the backsheet (18) are assembled together prior to assembly with the second outermost layer (22). For example, the second outermost layer (22) may be installed on an existing module that is already assembled in the field. In another embodiment, the first outermost layer (10), the photovoltaic cell (14), the backsheet (18), and the second outermost layer (22) are assembled simultaneously. In still another embodiment, the backsheet (18) and the second outermost layer (22) are assembled together prior to assembly with the first outermost layer (10) or the first outermost layer (10) and the photovoltaic cell (14).

The step of assembling may be further defined as contacting and/or compressing any one or more of the above with another. Even after the step of compressing, the photovoltaic cell (14) and the first outermost layer (10) do not need to be in direct contact with each other. The step of compressing may be further described as applying a vacuum, e.g. to the photovoltaic cell (14) and the first outermost layer (10). Alternatively, a mechanical weight, press, or roller (e.g. a pinch roller) may be used for compression. The step of compressing may be further described as laminating the module (26) and/or any one or more components described above. Still further, the method may include the step of applying heat to the module (26) and/or any one or more components described above. Heat may be applied in combination with any other step of contacting and/or compressing or may be applied in a discrete step. Vacuum may be applied in combination with any other contact and/or compressing step or may be applied in a discrete step. The entire method may be continuous or batch-wise or may include a combination of continuous and batch-wise steps.

It is contemplated that the second outermost layer (22) may be added to (e.g. contacted with) the backsheet (18) before, simultaneously with, or after any one or more of the other layers or components are assembled. In one embodiment, the second outermost layer (22) is applied to an existing module (26), e.g. already in use in the field. This may be described as retro-fitting an existing module (26) with the second outermost layer (22).

Alternatively, the photovoltaic cell (14) may be disposed directly on the backsheet (18) via chemical vapor deposition or physical sputtering. In yet another embodiment, the photovoltaic cell (14) is disposed directly on the first outermost layer (10) via chemical vapor deposition or physical sputtering. The photovoltaic cell (14) can be disposed (e.g. applied) by any suitable mechanism known in the art but is typically disposed using an applicator in a continuous mode. In one embodiment, the photovoltaic cell (14) is disposed on the first outermost layer (10) via chemical vapor deposition or physical sputtering. Other suitable mechanisms of disposing the photovoltaic cell (14) on the first outermost layer (10) include applying a force to the photovoltaic cell (14) to more completely contact the photovoltaic cell (14) and the first outermost layer (10).

Any of the aforementioned compositions of any component may be disposed using any suitable application method known in the art including, but not limited to, spray coating, flow coating, curtain coating, dip coating, extrusion coating, knife coating, screen coating, laminating, melting, pouring, brushing, and combinations thereof. In various embodiments, one or more silicone compositions are supplied as a multi-part system including a first and a second part. The first and second parts may be mixed immediately prior to application. In a further embodiment, the method further includes the step of partially curing, e.g. "pre-curing," any one or more of the aforementioned compositions.

In an additional embodiment, the method may include the step of treating the first outermost layer (10), the photovoltaic cell (14), the backsheet (18), and/or the second outermost layer (22) with a plasma, e.g. as described in U.S. Pat. No. 6,793,759, incorporated herein by reference.

### Bi-Laver Backsheet:

This disclosure also provides a bi-layer backsheet (not shown in the Figures) for a photovoltaic cell (14) module (26). The backsheet is typically resistant to soiling and delamination, has a thickness, and typically consists essentially of a perforated substrate and an anti-soiling layer disposed on the perforated substrate and in direct contact with perforations in the perforated substrate. For example, the anti-soiling layer may seal, partially seal, obstruct, or partially obstruct, one or more perforations. However, it is contemplated that the perforations may not always be present. In this embodiment, the backsheet may consist essentially of a non-perforated substrate and the anti-soling layer disposed thereon.

The bi-layer backsheet may be free-standing or supported on a support-member. The support member may be a rail or a plurality of pads used for rails or a pad supporting a PV cell panel or module at an installation site. Typically, the bi-layer backsheet is free-standing until deployed on/in a module (26) or bonded to the rail(s) or pad(s).

The perforated substrate may be further described as the backsheet is described above. However, the perforated substrate may be different from the backsheet. The perforations may be of any size, shape, and number and may extend completely through the perforated substrate or may extend only partially through the perforated substrate. In various embodiments, the perforations have a nanometer or micrometer size and are defined by various silicone polymers, e.g. one or more described above. The perforations themselves may be described as holes or tears which result as a coating defect or a tear during various manufacturing processes.

The anti-soiling layer may be further described as the second outermost layer (22) is described above. In one embodiment, the perforated substrate consists essentially of a first silicone. In another embodiment, the anti-soiling layer consists essentially of a second silicone different from the first silicone and exhibits a coefficient of friction, as described above relative to the second outermost layer (22). In still another embodiment, the anti-soiling layer is disposed on the perforated substrate at a coat weight of 10 to 15 g/m² at least partially obstructing the perforations. The aforementioned terminology set forth immediately above and throughout the disclosure of "obstructing" and/or "obstruct", and the like, may describe partial or complete physical obstruction from water vapor, water droplets, dirt, light, etc. by physical blocking, e.g. by reducing a size of the perforation, and/or by blocking via electrostatic interaction.

The bi-layer backsheet and the anti-soiling layer allow a photovoltaic cell module to resist soiling and delamination while increasing structural integrity such that the module can pass Wet Leakage Current tests. In addition, the bi-layer backsheet and the second outermost layer allow photovoltaic cell modules to be produced at reduced costs and with reduced complexities while decreasing weight and raw material usage. The anti-soiling layer may exhibit a coefficient of friction, as described above relative to the second outermost layer (22) of 0.1 to 0.7, 0.2 to 0.6, 0.3 to 0.5, 0.4 to 0.5, 0.1, 0.2, 0.3, 0.4, 0.5, 0.6, or 0.7, against itself measured according to ISO 8295. Typically, the lower the coefficient of friction, the less dirt, soil, particulates are retained by (e.g. stuck to) the anti-soiling layer.

The resistance to soiling of the bi-layer backsheet (and of the second outermost layer (22) described above) may be determine by comparing the cleaning of dirt from the anti-soiling layer and/or second outermost layer (22) with the cleaning of dirt from a substrate that does not include the anti-soiling layer and/or second outermost layer (22). For example, a layer of dirt (e.g. 5 grams per square meter) may be disposed on one of the aforementioned surfaces and then sprayed with a pre-determined amount of water from a water source (such as a laboratory water bottle). After spraying with water, the amount of dirt remaining could be quantified by weight and/or visual evaluations.

### Method of Generating Electricity:

This disclosure also provides a method of generating electricity utilizing the module (26) of this disclosure. The method includes the step of exposing the module to sunlight to generate the electricity. The method may also include the step of transmitting the electricity via an electrical conduit from the photovoltaic cell module to an electrical device to power the electrical device. The electrical conduit is not particularly limited and may include power lines, piping, transmission lines, wires, cables, high voltage direct current (HVDC) transmission systems, etc. In one embodiment, the conduit extends from one city, township, village, county, state, territory, province, region, or country into another area. An array of modules (26) may also be utilized in this disclosure and this method. The method may also include the step of powering the electrical device with the electricity to generate light, heat, a voltage differential, or a motive force.

In another embodiment the disclosure provides a method of powering an electrical device with electricity generated by a photovoltaic cell module comprising the first outermost layer having a light transmittance of at least 70 percent as determined by UV/Vis spectrophotometry using ASTM E424-71 (2007), the photovoltaic cell disposed on the first outermost layer; the backsheet disposed on the photovoltaic cell, and the second outermost layer opposite the first outermost layer, wherein the second outermost layer is disposed on an outward facing surface of the backsheet sandwiching the photovoltaic cell and the backsheet between the second outermost layer and the first outermost layer. In this embodiment, the second outermost layer is present in a coating weight of from 3 to 75 g/m² of the outward facing surface of the backsheet and the backsheet and the second outermost layer each independently consist essentially of a silicone. Moreover in this embodiment the photovoltaic cell module passes the Wet Leakage Current Test at a voltage of at least 1000 V using IEC 61215 after humidity cycling for 1,000 hours. In this embodiment, the method includes the steps of exposing the photovoltaic cell module to sunlight to generate the electricity, transmitting the electricity via an electrical conduit from the photovoltaic cell module to an electrical device to power the electrical device, and powering the electrical device, or an electrical component thereof, with the electricity. The electrical device may include an electric appliance (e.g., kitchen, lighting), a battery, a communication device (e.g., cellular telephone, fixed-line telephone, television, radio) a computing device (personal computer, server, tablet), a electronic display (LCD, plasma, LED, CRT), an electric motor, or an electric vehicle.

### EXAMPLES

### Formation of Modules:

A series of (Modules 1-19) are formed according to the method of instant disclosure. In addition, nine comparative modules (Comparative Modules 1-9) are also formed but not according to the method of the instant disclosure.

Each Module 1-19 includes:
A 156 mm x 156 mm x 3.2 mm first outermost layer (glass) having a light transmittance of at least 70 percent as determined by UV/Vis spectrophotometry using ASTM E424-71 (2007);
A 156 mm x 156 mm x 200 µm photovoltaic cell disposed on the first outermost layer;
A 156 mm x 156 mm front side encapsulant disposed on and in direct contact with, and sandwiched between, both the first outermost layer and the photovoltaic cell;
A 156 mm x 156 mm back sheet disposed on and in direct contact with, and sandwiched between, both the back side encapsulant and a second outermost layer; and
A 156 mm x 156 mm second outermost layer.

Modules 1, 3, 5, 7, 10, 12, and 14 also include a 156 mm x 156 mm scrim fiberglass layer disposed within, and encapsulated by, the back side encapsulant.

Each Comparative Module 1-9 includes the first outermost layer, the photovoltaic cell, the front and back side encapsulants, and a backsheet. However, none of the Comparative Modules include a second outermost layer of this disclosure. The components used to form each of the Modules 1-19 and the Comparative Modules 1-9 are set forth in Table 1 below:

**TABLE 1**

| **Module** | **Backsheet** | **Front Side/Back Side Encapsulants** | **Fiberglass of Backsheet Facing Superstrate** | **First Outermost Layer** | **Second Outermost Layer** |
|---|---|---|---|---|---|
| **Comp**. **Mod**. **1** | A | Encap. 1/Encap. 2 | Fiberglass 1 | Glass | None |
| | | Scrim in Encap. 2 | | | |
| **Comp**. **Mod**. **2** | B | Encap. 1/Encap. 2 | Fiberglass 1 | Glass | None |
| | | Scrim in Encap. 2 | | | |
| **Comp**. **Mod**. **3** | B | Encap. 3/Encap. 3 | Fiberglass 1 | Glass | None |
| **Comp**. **Mod**. **4** | C | Encap. 1/Encap. 2 | Fiberglass 1 | Glass | None |
| | | Scrim in Encap. 2 | | | |
| **Comp**. **Mod**. **5** | C | Encap. 3/Encap. 3 | Fiberglass 1 | Glass | None |
| **Comp**. **Mod**. **6** | D | Encap. 1/Encap. 2 | Fiberglass 2 | Glass | None |
| | | Scrim in Encap. 2 | | | |
| **Comp**. **Mod**. **7** | D | Encap. 3/Encap. 3 | Fiberglass 2 | Glass | None |
| **Comp**. **Mod**. **8** | E on Fiberglass 3 | Encap. 1/Encap. 2 | Fiberglass 3 | Glass | None |
| | | Scrim in Encap. 2 | | | |
| **Comp**. **Mod**. **9** | E on Fiberglass 3 | Encap. 3/Encap. 3 | Fiberglass 3 | Glass | None |
| **Mod**. **1** | B | Encap. 1/Encap. 2 | Fiberglass 1 | Glass | Top Coat |
| | | Scrim in Encap. 2 | | | |
| **Mod**. **2** | B | Encap. 3/Encap. 3 | Fiberglass 1 | Glass | Top Coat |
| **Mod**. **3** | C | Encap. 1/Encap. 2 | Fiberglass 1 | Glass | Top Coat |
| | | Scrim in Encap. 2 | | | |
| **Mod**. **4** | C | Encap. 3/Encap. 3 | Fiberglass 1 | Glass | Top Coat |
| **Mod**. **5** | D | Encap. 1/Encap. 2 | Fiberglass 2 | Glass | Top Coat |
| | | Scrim in Encap. 2 | | | |
| **Mod**. **6** | D | Encap. 3/Encap. 3 | Fiberglass 2 | Glass | Top Coat |
| **Mod**. **7** | E | Encap. 1/Encap. 2 | Fiberglass 2 | Glass | Top Coat |
| | | Scrim in Encap. 2 | | | |
| **Mod**. **7** | E | Encap. 1/Encap. 2 | Fiberglass 2 | Glass | Top Coat |
| | | Scrim in Encap. 2 | | | |
| **Mod**. **7** | E | Encap. 1/Encap. 2 | Fiberglass 2 | Glass | Top Coat |
| | | Scrim in Encap. 2 | | | |
| **Mod**. **8** | E | Encap. 3/Encap. 3 | Fiberglass 2 | Glass | Top Coat |
| **Mod**. **8** | E | Encap. 3/Encap. 3 | Fiberglass 2 | Glass | Top Coat |
| **Mod**. **8** | E | Encap. 3/Encap. 3 | Fiberglass 2 | Glass | Top Coat |
| **Mod**. **9** | F | Encap. 1/Encap. 2 Scrim in Encap. 2 | Fiberglass 2 | Glass | Top Coat |
| **Mod**. **10** | G | Encap. 1/Encap. 2 | Fiberglass 2 | Glass | Top Coat |
| | | Scrim in Encap. 2 | | | |
| **Mod**. **11** | G | Encap. 3/Encap. 3 | Fiberglass 2 | Glass | Top Coat |
| **Mod**. **12** | H | Encap. 1/Encap. 2 | Fiberglass 2 | Glass | Top Coat |
| | | Scrim in Encap. 2 | | | |
| **Mod**. **13** | H | Encap. 3/Encap. 3 | Fiberglass 2 | Glass | Top Coat |
| **Mod**. **14** | E on Fiberglass 3 | Encap. 1/Encap. 2 | Fiberglass 3 | Glass | Top Coat |
| | | Scrim in Encap. 2 | | | |
| **Mod**. **15** | E on Fiberglass 3 | Encap. 3/Encap. 3 | Fiberglass 3 | Glass | Top Coat |
| **Mod**. **16** | E on Fiberglass 4 | Encap. 1/Encap. 2 | Fiberglass 4 | Glass | Top Coat |
| | | Scrim in Encap. 2 | | | |
| **Mod**. **17** | E on Fiberglass 4 | Encap. 3/Encap. 3 | Fiberglass 4 | Glass | Top Coat |
| **Mod**. **18** | E on Fiberglass 5 | Encap. 1/Encap. 2 | Fiberglass 5 | Glass | Top Coat |
| | | Scrim in Encap. 2 | | | |
| **Mod**. **19** | E on Fiberglass 5 | Encap. 3/Encap. 3 | Fiberglass 5 | Glass | Top Coat |

Backsheet A is a high consistency rubber calendared onto a woven fiberglass (Fiberglass 1) at a 5 mil thickness. The high consistency rubber is a hydrosilylation reaction product of a dimethylvinyl terminated siloxane and a dimethylhydrogen siloxane catalyzed by platinum and includes quartz filler and pigments. This backsheet is coated by Arlon.

Backsheet B is a high consistency rubber calendared onto a woven fiberglass (Fiberglass 1) at a 10 mil thickness. The high consistency rubber is a hydrosilylation reaction product of a dimethylvinyl terminated siloxane and a dimethylhydrogen siloxane catalyzed by platinum and includes quartz filler and pigments. This backsheet is coated by Arlon.

Backsheet C is a liquid silicone rubber coated onto a woven fiberglass (Fiberglass 1) at a 10 mil thickness. The liquid silicone rubber is a hydrosilylation reaction product of a dimethylvinyl terminated siloxane and a dimethylhydrogen siloxane catalyzed by platinum and includes aluminum trihydrate filler and pigments. This backsheet is coated by Von Roll.

Backsheet D is a liquid silicone rubber coated onto a woven fiberglass (Fiberglass 2) at a 10 mil thickness. The liquid silicone rubber is a hydrosilylation reaction product of a dimethylvinyl terminated siloxane and a dimethylhydrogen siloxane catalyzed by platinum and includes aluminum trihydrate filler and pigments. This backsheet is coated by Von Roll.

Backsheet E is a liquid silicone rubber coated onto a woven fiberglass (Fiberglass 2) at approximately 120 g/m². The liquid silicone rubber is a hydrosilylation reaction product of a dimethylvinyl terminated siloxane and a dimethyl hydrogen siloxane catalyzed by platinum. It includes fumed silica and pigments. It is coated with a talc containing hard top coat which is a reaction product of a Hydroxy-terminated Dimethyl, Methylvinyl Siloxane, a Dimethylvinylsiloxy-terminated Siloxane and platinum coated at approximately 15 g/m²

Backsheet F is a liquid silicone rubber coated onto a woven fiberglass (Fiberglass 2) at approximately 180 g/m². The liquid silicone rubber is a hydrosilylation reaction product of a dimethylvinyl terminated siloxane and a dimethyl hydrogen siloxane catalyzed by platinum. It includes fumed silica and pigments. It is coated with a talc containing hard top coat which is a reaction product of a Hydroxy-terminated Dimethyl, Methylvinyl Siloxane, a Dimethylvinylsiloxy-terminated Siloxane and platinum coated at approximately 15 g/m².

Backsheet G is a liquid silicone rubber coated onto a woven fiberglass (Fiberglass 2) at approximately 300 g/m². The liquid silicone rubber is a hydrosilylation reaction product of a dimethylvinyl terminated siloxane and a dimethyl hydrogen siloxane catalyzed by platinum. It includes fumed silica and pigments. It is coated with a talc containing hard top coat which is a reaction product of a Hydroxy-terminated Dimethyl, Methylvinyl Siloxane, a Dimethylvinylsiloxy-terminated Siloxane and platinum coated at approximately 15 g/m².

Backsheet H is a liquid silicone rubber coated onto a woven fiberglass (Fiberglass 2) on two sides at 60 g/m² on both sides. The liquid silicone rubber is a hydrosilylation reaction product of a dimethylvinyl terminated siloxane and a dimethyl hydrogen siloxane catalyzed by platinum. It includes fumed silica and pigments. It is coated on one side with a talc containing hard top coat which is a reaction product of a Hydroxy-terminated Dimethyl, Methylvinyl Siloxane, a Dimethylvinylsiloxy-terminated Siloxane and platinum coated at approximately 15 g/m².

Encapsulant 1 is a low modulus (front side) encapsulant and is the hydrosilylation reaction product of two different dimethylvinyl-terminated polydimethylsiloxanes, a dimethylhydrogen-terminated polydimethylsiloxane and a trimethylsiloxy-terminated dimethyl methylhydrogen siloxane containing at least 3 SiH units per molecule, catalyzed by platinum and includes PDMS.

Encapsulant 2 is a low modulus (backside) encapsulant and is the hydrosilylation reaction product of a dimethylvinyl-terminated polydimethylsiloxane, a dimethylhydrogen-terminated polydimethylsiloxane and a trimethylsiloxy-terminated dimethyl methylhydrogen siloxane containing at least 3 SiH units per molecule catalyzed by platinum.

Encapsulant 3 is a high modulus (PV) encapsulant and is the hydrosilylation reaction product of a dimethylvinyl-terminated polydimethylsiloxane and a trimethylsiloxy-terminated dimethyl methylhydrogen siloxane containing at least 3 SiH units per molecule catalyzed by platinum.

Fiberglass 1 is a woven fiberglass from JPS composites with a thickness of 7 mils.

Fiberglass is a woven fiberglass from JPS composites with a thickness of 4.8 mils.

Fiberglass 3 is a woven fiberglass from JPS composites with a thickness of 5 mils.

Fiberglass 4 is a woven fiberglass from JPS composites with a thickness of 5.9 mils.

Fiberglass 5 is a woven fiberglass from JPS composites with a thickness of 4.4mils.

After formation, three samples of various Modules 1-19 and the Comparative Modules 1-9 are evaluated pursuant to a IEC 61215 (humidity cycling) and Thermal Cycling to determine whether the Module passes Power and Wet Leakage tests at various time intervals. The results are set forth in Tables 2 and 3 below.

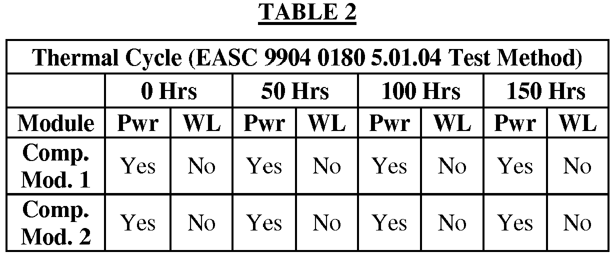

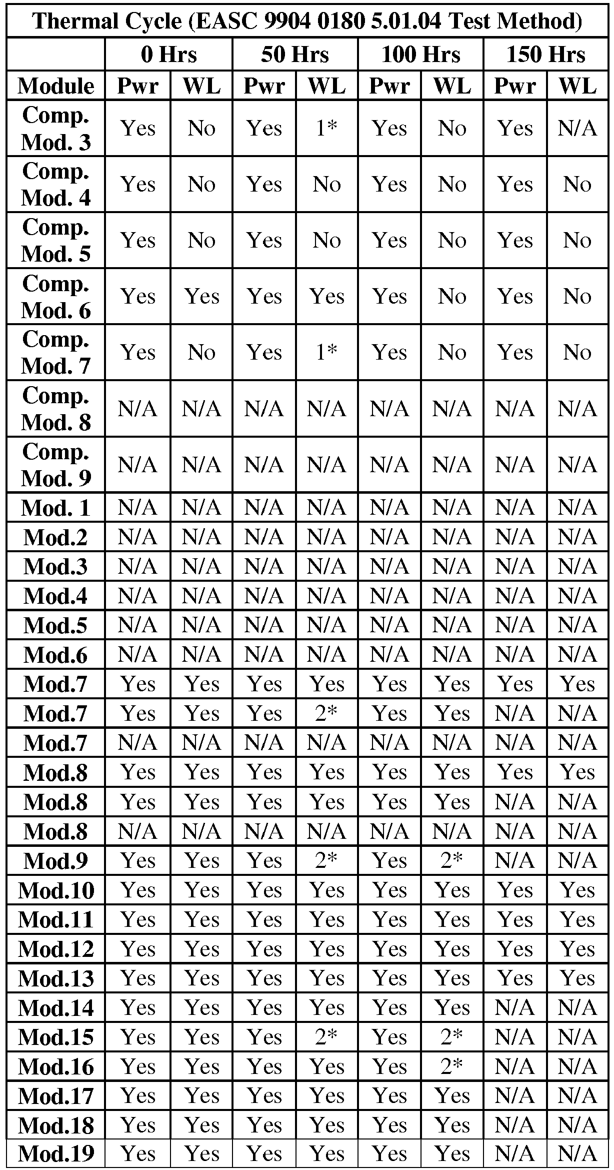

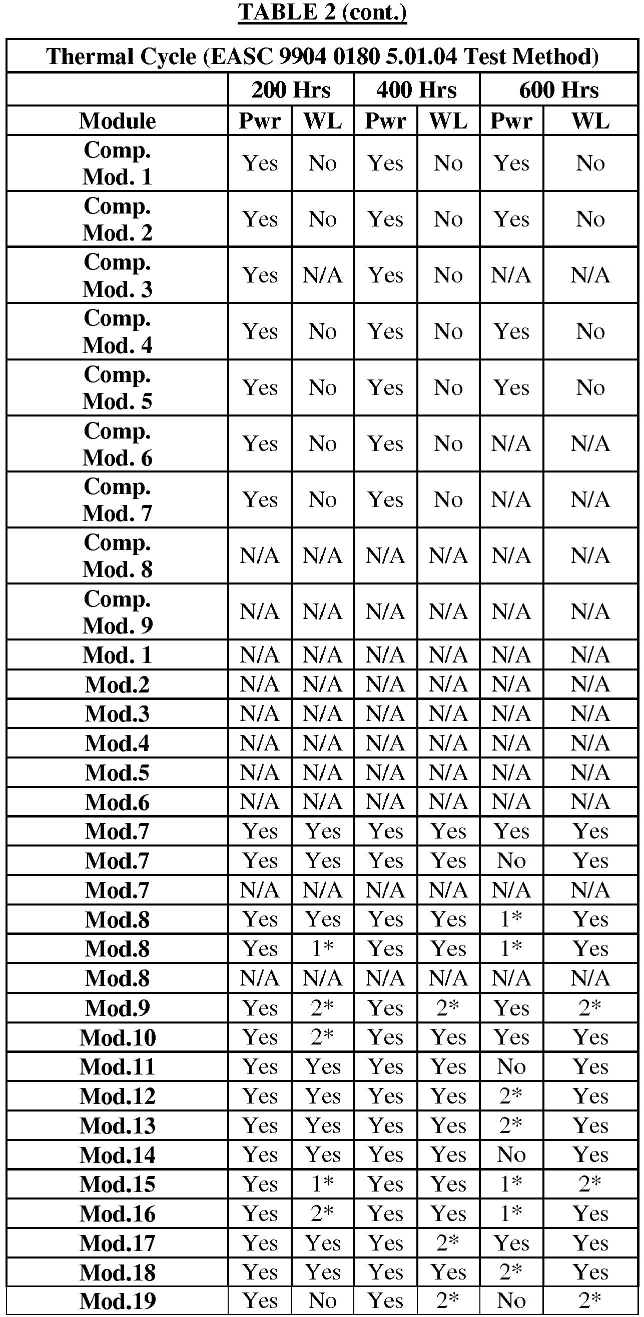

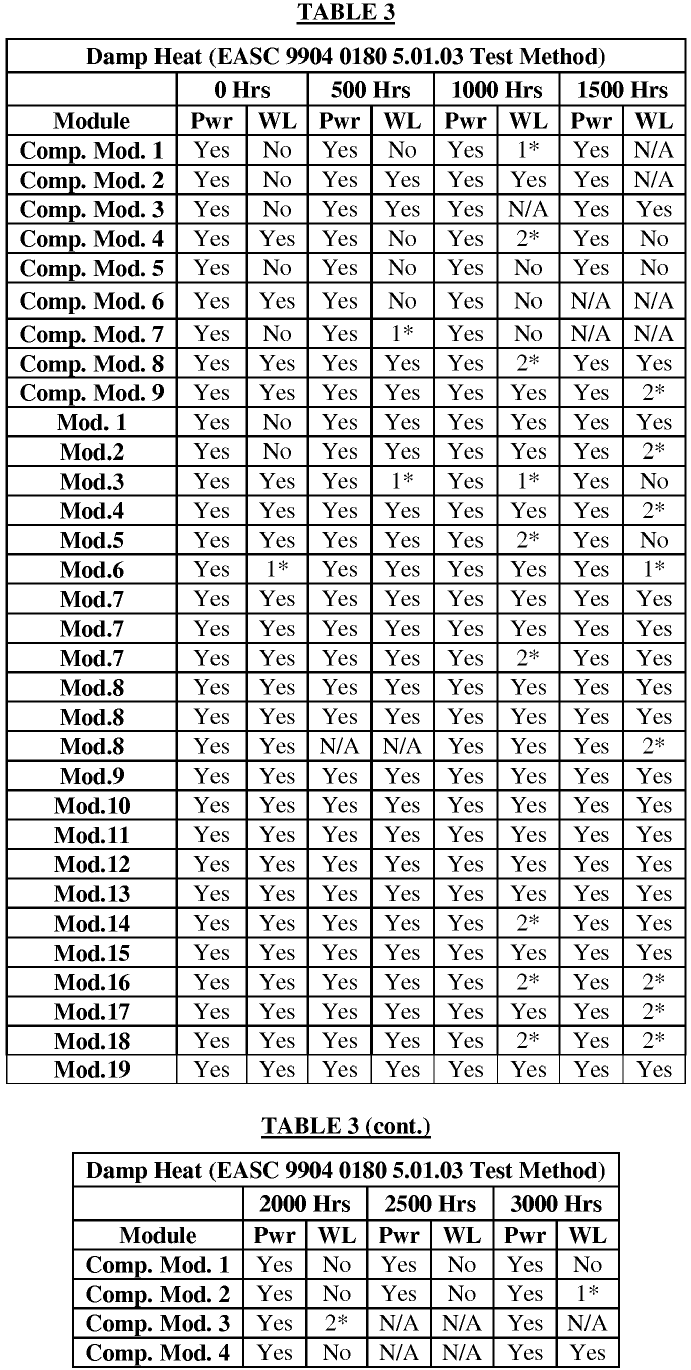

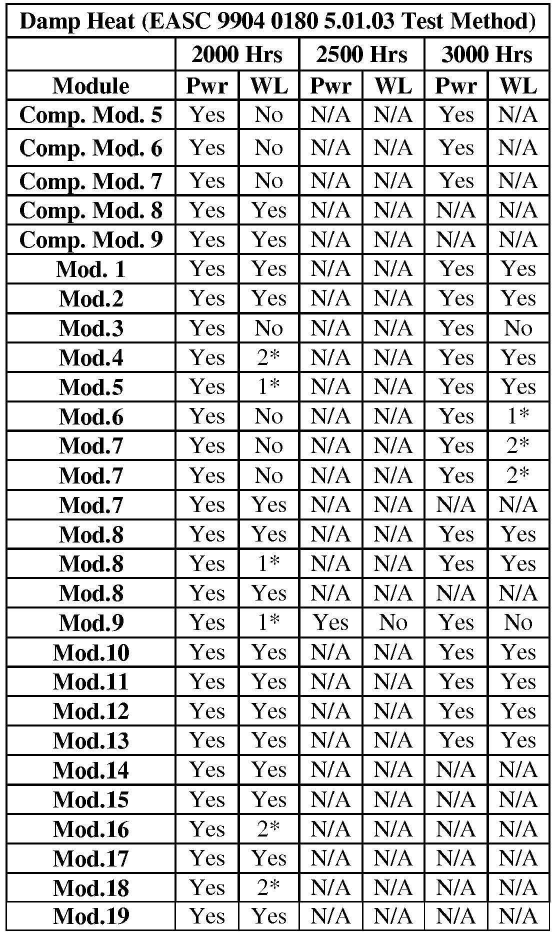

In Tables 2 and 3 above, the terminology "Yes" is indicative of all three samples passing the respective evaluation. The terminology "2*" is indicative that two of three samples passed the respective evaluation. The terminology "1*" is indicative that one of three samples passed the respective evaluation. The terminology "No" is indicative that all three samples failed the respective evaluation. The terminology "N/A" is indicative that the evaluation was not performed.

## Claims

1. A photovoltaic cell module comprising:
A. a first outermost layer having a light transmittance of at least 70 percent as determined by UV/Vis spectrophotometry using ASTM E424-71 (2007);
B. a photovoltaic cell disposed on said first outermost layer;
C. a backsheet disposed on said photovoltaic cell; and
D. a second outermost layer opposite said first outermost layer, said second outermost layer disposed on an outward facing surface of said backsheet sandwiching said photovoltaic cell and said backsheet between said second outermost layer and said first outermost layer,
wherein said second outermost layer is present in a coating weight of from 3 to 75 grams per square meter of the outward facing surface of said backsheet,
wherein said backsheet and said second outermost layer each independently consist essentially of a silicone, and
wherein said photovoltaic cell module passes the Wet Leakage Current Test at a voltage of at least 1000 Volts using IEC 61215 after humidity cycling for 1,000 hours.

2. The photovoltaic cell module of claim 1 wherein said silicone of said second outermost layer is a product of a reaction between:
(A) an organopolysiloxane having a degree of polymerization of less than or equal to 150 and terminated with at least two silicon-bonded R groups, wherein each R group is independently an olefinically unsaturated group, an alkoxy group, or a hydroxyl group; and
(B) an organosilicon cross-linker having at least 3 silicon-bonded groups reactive with one or more of said R groups; in the presence of
(C) an effective amount of a catalyst that catalyzes a reaction between (A) and (B) that forms the silicone of said second outermost layer.

3. The photovoltaic cell module of claim 2 wherein (A) and (B) are reacted in the presence of a filler chosen from a metallic filler, an inorganic filler, a meltable filler, and combinations thereof and wherein said second outermost layer further comprises said filler; or wherein (A) and (B) are reacted in the presence of talc in an amount of from 2 to 70 weight percent based on a total weight of said second outermost layer and wherein said silicone of said second outermost layer further comprises said talc; or wherein (A) and (B) are reacted together in the presence of titanium dioxide in an amount of up to about 30 weight percent based on a total weight of said second outermost layer wherein a total amount of titanium dioxide and optionally talc does not exceed 45 weight percent based on a total weight of said second outermost layer and wherein said silicone of said second outermost layer further comprises said titanium dioxide and optionally said talc.

4. The photovoltaic cell module of any one of claims 2 to 3 wherein said catalyst is a hydrosilylation catalyst and said silicone of said second outermost layer is a hydrosilylation product of a reaction between (A) and (B); or wherein said silicone of said second outermost layer comprises a product of a reaction between (A) and (B); or wherein (A) comprises 10 to 50 mole percent of vinylmethylsiloxane units based on a total number of moles of (A); or wherein (A) comprises both silicon-bonded vinyl groups and silicon-bonded hydroxyl groups in a single molecule.

5. The photovoltaic cell module of any preceding claim wherein said backsheet consists essentially of a silicone different in composition from the composition of said silicone of said second outermost layer.

6. The photovoltaic cell module of any preceding claim wherein said backsheet further comprises a plurality of fibers; or wherein said backsheet further comprises a plurality of fibers and wherein said plurality of fibers is further described as a woven plurality of fibers.

7. The photovoltaic cell of any preceding claim wherein said second outermost layer exhibits a coefficient of friction of 0.1 to 0.7 against itself measured according to ISO 8295.

8. A photovoltaic cell module comprising:
a first outermost layer having a light transmittance of at least 70 percent as determined by UV/Vis spectrophotometry using ASTM E424-71 (2007);
a photovoltaic cell having a front side and a back side and disposed on said first outermost layer;
an encapsulant disposed on and in direct contact with said front side and said back side of said photovoltaic cell,
a backsheet comprising woven fiberglass and disposed on said encapsulant; and
a second outermost layer opposite said first outermost layer, said second outermost disposed on an outward facing surface of said backsheet sandwiching said photovoltaic cell, said encapsulant, and said backsheet between said second outermost layer and said first outermost layer,
wherein said second outermost layer is present in a coating weight of from 10 to 20 grams per square meter of the outward facing surface of said backsheet,
wherein said photovoltaic cell module passes the Wet Leakage Current Test at a voltage of at least 1000 Volts using IEC 61215 after humidity cycling for 1,000 hours,
wherein said second outermost layer is the hydrosilylation product of a reaction between:
an organopolysiloxane having an average of at least two silicon-bonded alkenyl groups or silicon-bonded hydrogen atoms per molecule; and
an organosilicon compound in an amount sufficient to cure the organopolysiloxane, wherein the organosilicon compound has an average of at least two silicon-bonded hydrogen atoms or silicon-bonded alkenyl groups per molecule capable of reacting with the silicon-bonded alkenyl groups or silicon-bonded hydrogen atoms in the organopolysiloxane; in the presence of
a catalytic amount of a hydrosilylation catalyst.

9. A method of forming a photovoltaic cell module comprising a first outermost layer having a light transmittance of at least 70 percent as determined by UV/Vis spectrophotometry using ASTM E424-71 (2007), a photovoltaic cell disposed on the first outermost layer, a backsheet disposed on the photovoltaic cell, and a second outermost layer opposite the first outermost layer and disposed on an outward facing surface of the backsheet sandwiching the photovoltaic cell and the backsheet between the second outermost layer and the first outermost layer, wherein said second outermost layer is present in a coating weight of from 3 to 75 grams per square meter of the outward facing surface of said backsheet, wherein said backsheet and said second outermost layer each independently consist essentially of a silicone, and wherein said photovoltaic cell module passes the Wet Leakage Current Test at a voltage of at least 1000 Volts using IEC 61215 after humidity cycling for 1,000 hours, said method comprising the step of assembling the first outermost layer, the photovoltaic cell, the backsheet, and the second outermost layer to form the photovoltaic cell module.

10. A bi-layer backsheet for a photovoltaic cell module, said backsheet being resistant to soiling and delamination, having a thickness, and consisting essentially of:
A. a perforated substrate; and
B. an anti-soiling layer disposed on said perforated substrate and in direct contact with perforations in said perforated substrate,
wherein said anti-soiling layer has a thickness that is less than 10percent of said thickness of said perforated substrate,
wherein said perforated substrate consists essentially of a first silicone,
wherein said anti-soiling layer consists essentially of a second silicone different from said first silicone and exhibits a coefficient of friction of 0.1 to 0.7 against itself measured according to ISO 8295, and
wherein said anti-soiling layer is disposed on said perforated substrate at a coat weight of 3 to 75 grams per square meter of said perforated substrate at least partially obstructing said perforations.

11. The bi-layer backsheet of claim 10 wherein said first silicone is a product of a reaction between:
(A) an organopolysiloxane having a degree of polymerization of less than or equal to 150 and terminated with at least two silicon-bonded R groups, wherein each R group is independently an olefinically unsaturated group, an alkoxy group, or a hydroxyl group; and
(B) an organosilicon cross-linker having at least 3 silicon-bonded groups reactive with one or more of said R groups; in the presence of
(C) an effective amount of a catalyst that catalyzes a reaction between (A) and (B) that forms the silicone of said second outermost layer.

12. A method of generating electricity using a photovoltaic cell module comprising:
a first outermost layer having a light transmittance of at least 70 percent as determined by UV/Vis spectrophotometry using ASTM E424-71 (2007);
a photovoltaic cell disposed on said first outermost layer;
a backsheet disposed on said photovoltaic cell; and
a second outermost layer opposite said first outermost layer, said second outermost layer disposed on said backsheet sandwiching said photovoltaic cell and said backsheet between said second outermost layer and said first outermost layer,
wherein said second outermost layer is present in a coating weight of from 3 to 75 g/m²,
wherein said backsheet and said second outermost layer each independently consist essentially of a silicone, and
wherein said photovoltaic cell module passes the Wet Leakage Current Test at a voltage of at least 1000 V using IEC 61215 after humidity cycling for 1,000 hours, wherein said method comprises the step of exposing the photovoltaic cell module to sunlight to generate the electricity.

13. A method of powering an electrical device with electricity generated by a photovoltaic cell module comprising:
a first outermost layer having a light transmittance of at least 70 percent as determined by UV/Vis spectrophotometry using ASTM E424-71 (2007);
a photovoltaic cell disposed on said first outermost layer;
a backsheet disposed on said photovoltaic cell; and
a second outermost layer opposite said first outermost layer, said second outermost layer disposed on said backsheet sandwiching said photovoltaic cell and said backsheet between said second outermost layer and said first outermost layer,
wherein said second outermost layer is present in a coating weight of from 3 to 75 g/m²,
wherein said backsheet and said second outermost layer each independently consist essentially of a silicone, and
wherein said photovoltaic cell module passes the Wet Leakage Current Test at a voltage of at least 1000 V using IEC 61215 after humidity cycling for 1,000 hours, wherein said method comprises the steps of:
exposing the photovoltaic cell module to sunlight to generate the electricity;
transmitting the electricity via an electrical conduit from the photovoltaic cell module to an electrical device to power the electrical device;
and powering the electrical device, or an electrical component thereof, with said electricity.

## Patentansprüche

1. Fotovoltaik-Zellmodul, Folgendes umfassend:
A. eine erste äußerste Schicht mit einer Lichtdurchlässigkeit von mindestens 70 Prozent entsprechend der Bestimmung durch UV/Vis-Spektrofotometrie unter Verwendung von ASTM E424-71 (2007);
B. eine Fotovoltaik-Zelle, angeordnet auf der ersten äußersten Schicht;
C. eine Rückseite, angeordnet an der Fotovoltaik-Zelle; und
D. eine zweite äußerste Schicht gegenüber der ersten äußersten Schicht, wobei die zweite äußerste Schicht an einer nach außen weisenden Fläche der Rückseite angeordnet ist und die Fotovoltaik-Zelle und die Rückseite zwischen der zweiten äußersten Schicht und der ersten äußersten Schicht einklemmt,
wobei die zweite äußerste Schicht mit einem Auftragsgewicht von 3 bis 75 Gramm pro Quadratmeter der nach außen weisenden Fläche der Rückseite vorliegt,
wobei die Rückseite und die zweite äußerste Schicht jeweils unabhängig im Wesentlichen aus einem Silikon bestehen, und
wobei das Fotovoltaik-Zellmodul die Kriechstromprüfung unter Benässung bei einer Spannung von mindestens 1000 Volt unter Anwendung von IEC 61215 nach Feuchtigkeitswechsel über 1.000 Stunden besteht.

2. Fotovoltaik-Zellmodul nach Anspruch I, wobei das Silikon der zweiten äußersten Schicht ein Reaktionsprodukt zwischen Folgenden ist:
(A) einem Organopolysiloxan mit einem Polymerisationsgrad von weniger als oder gleich 150, terminiert mit mindestens zwei silikongebundenen R-Gruppen, wobei jede R-Gruppe unabhängig eine olefinisch ungesättigte Gruppe, eine Alkoxygruppe oder eine Hydroxylgruppe ist; und
(B) einem Organosilicium-Vernetzer mit mindestens 3 silikongebundenen Gruppen, die mit einer oder mehreren der R-Gruppen reagieren; bei Vorliegen von
(C) einer effektiven Menge eines Katalysators, der eine Reaktion zwischen (A) und (B) katalysiert, die das Silikon der zweiten äußersten Schicht bildet.

3. Fotovoltaik-Zellmodul nach Anspruch 2, wobei (A) und (B) bei Vorliegen eines Füllmaterials reagieren, das ausgewählt ist aus einem metallischen Füllmaterial, einem anorganischen Füllmaterial, einem schmelzbaren Füllmaterial und Kombinationen daraus, und wobei die zweite äußerste Schicht das Füllmaterial umfasst; oder wobei (A) und (B) reagieren unter Vorliegen von Talkum in einer Menge von 2 Gew.-% bis 70 Gew.-%, basierend auf einem Gesamtgewicht der zweiten äußersten Schicht, und wobei das Silikon der zweiten äußersten Schicht weiter das Talkum umfasst; oder wobei (A) und (B) zusammen reagieren bei Vorliegen von Titandioxid in einer Menge von etwa 30 Gew.-% basierend auf einem Gesamtgewicht der zweiten äußersten Schicht, wobei eine Gesamtmenge von Titandioxid und wahlfrei Talkum nicht 45 Gew.-% überschreitet, basierend auf einem Gesamtgewicht der zweiten äußersten Schicht, und wobei das Silikon der zweiten äußersten Schicht weiter das Titandioxid und wahlfrei das Talkum umfasst.

4. Fotovoltaik-Zellmodul nach einem der Ansprüche 2 bis 3, wobei der Katalysator ein Hydrosilylierungs-Katalysator ist und das Silikon der zweiten äußersten Schicht ein Hydrosilylierungsprodukt einer Reaktion zwischen (A) und (B) ist; oder wobei das Silikon der zweiten äußersten Schicht ein Produkt einer Reaktion zwischen (A) und (B) umfasst; oder wobei (A) 10 bis 50 Molprozent Vinylmethylsiloxan-Einheiten umfasst, basierend auf einer Gesamtzahl von Molen von (A); oder wobei (A) sowohl silikongebundene Vinylgruppen als auch silikongebundene Hydroxylgruppen in einem einzelnen Molekül umfasst.

5. Fotovoltaik-Zellmodul nach einem der vorstehenden Ansprüche, wobei die Rückseite im Wesentlichen aus einem Silikon besteht, das sich in der Zusammensetzung unterscheidet von der Zusammensetzung des Silikons der zweiten äußersten Schicht.

6. Fotovoltaik-Zellmodul nach einem der vorstehenden Ansprüche, wobei die Rückseite weiter eine Vielzahl von Fasern umfasst; oder wobei die Rückseite weiter eine Vielzahl von Fasern umfasst und wobei die Vielzahl von Fasern weiter beschrieben ist als eine gewebte Vielzahl von Fasern.

7. Fotovoltaik-Zellmodul nach einem der vorstehenden Ansprüche, wobei die zweite äußerste Schicht einen Reibungskoeffizienten von 0,1 bis 0,7 gegen sich selbst aufweist, gemessen gemäß ISO 8295.

8. Fotovoltaik-Zellmodul, Folgendes umfassend:
eine erste äußerste Schicht mit einer Lichtdurchlässigkeit von mindestens 70 Prozent entsprechend der Bestimmung durch UV/Vis-Spektrofotometrie unter Verwendung von ASTM E424-71 (2007);
eine Fotovoltaik-Zelle mit einer vorderen Seite und einer hinteren Seite, angeordnet auf der ersten äußersten Schicht;
eine Verkapselung, angeordnet an und in direktem Kontakt mit der vorderen Seite und der hinteren Seite der Fotovoltaik-Zelle,
eine Rückseite, umfassend gewebte Glasfaser und angeordnet auf der Verkapselung; und
eine zweite äußerste Schicht gegenüber der ersten äußersten Schicht, wobei die zweite äußerste Schicht an einer nach außen weisenden Fläche der Rückseite angeordnet ist und die Fotovoltaik-Zelle, die Verkapselung und die Rückseite zwischen der zweiten äußersten Schicht und der ersten äußersten Schicht einklemmt,
wobei die zweite äußerste Schicht mit einem Auftragsgewicht von 10 bis 20 Gramm pro Quadratmeter der nach außen weisenden Fläche der Rückseite vorliegt,
wobei das Fotovoltaik-Zellmodul die Kriechstromprüfung unter Benässung bei einer Spannung von mindestens 1000 Volt unter Anwendung von IEC 61215 nach Feuchtigkeitswechsel über 1.000 Stunden besteht,
wobei die zweite äußerste Schicht das Hydrosilylierungsprodukt einer Reaktion zwischen Folgenden ist:
einem Organopolysiloxan mit durchschnittlich mindestens zwei Silicium-gebundenen Alkenylgruppen oder Silicium-gebundenen Wasserstoffatomen pro Molekül; und
einer Organosilicium-Verbindung in einer ausreichenden Menge, um das Organopolysiloxan auszuhärten, wobei die Organosilicium-Verbindung durchschnittlich mindestens zwei Silicium-gebundene Wasserstoffatome oder Silicium-gebundene Alkenylgruppen pro Molekül hat, das mit den Silicium-gebundenen Alkenylgruppen oder Silicium-gebundenen Wasserstoffatomen im Organopolysiloxan reagieren kann; bei Vorliegen von
einer katalytischen Menge eines Hydrosilylierungs-Katalysators.

9. Verfahren zum Bilden eines Fotovoltaik-Zellmoduls, umfassend eine erste äußerste Schicht mit einer Lichtdurchlässigkeit von mindestens 70 Prozent entsprechend der Bestimmung durch UV/Vis-Spektrofotometrie unter Verwendung von ASTM E424-71 (2007), eine Fotovoltaik-Zelle, angeordnet auf der ersten äußersten Schicht, eine Rückseite, angeordnet auf der Fotovoltaik-Zelle, und eine zweite äußerste Schicht gegenüber der ersten äußersten Schicht und angeordnet auf einer nach außen weisenden Fläche der Rückseite, wobei die Fotovoltaik-Zelle und die Rückseite zwischen der zweiten äußersten Schicht und der ersten äußersten Schicht eingeklemmt werden, wobei die zweite äußerste Schicht mit einem Auftragsgewicht von 3 Gramm bis 75 Gramm pro Quadratmeter der nach außen weisenden Fläche der Rückseite vorliegt; wobei die Rückseite und die zweite äußerste Schicht jeweils unabhängig im Wesentlichen aus einem Silikon bestehen und wobei das Fotovoltaik-Zellmodul die Kriechstromprüfung unter Benässung bei einer Spannung von mindestens 1.000 Volt unter Anwendung von IEC 61215 nach Feuchtigkeitswechsel über 1.000 Stunden besteht, wobei das Verfahren den Schritt des Zusammensetzens der ersten äußersten Schicht, der Fotovoltaik-Zelle, der Rückseite und der zweiten äußersten Schicht umfasst, um das Fotovoltaik-Zellmodul zu bilden.

10. Zweischichtige Rückseite für ein Fotovoltaik-Zellmodul, wobei die Rückseite widerstandsfähig gegen Verschmutzung und Schichtablösung ist und eine Dicke aufweist und im Wesentlichen aus Folgendem besteht:
A. einem perforierten Substrat; und
B. einer schmutzabweisenden Schicht, angeordnet auf dem perforierten Substrat und in direktem Kontakt mit Perforationen im perforiertem Substrat,
wobei die schmutzabweisende Schicht eine Dicke hat, die geringer ist als 10 Prozent der Dicke des perforierten Substrats,
wobei das perforierte Substrat im Wesentlichen aus einem ersten Silikon besteht,
wobei die schmutzabweisende Schicht im Wesentlichen aus einem zweiten Silikon besteht, das sich vom ersten Silikon unterscheidet, und einen Reibungskoeffizienten von 0,1 bis 0,7 gegen sich selbst aufweist, gemessen gemäß ISO 8295, und
wobei die schmutzabweisende Schicht auf dem perforierten Substrat mi einem Auftragsgewicht von 3 bis 75 Gramm pro Quadratmeter des perforierten Substrats angeordnet ist und die Perforationen zumindest teilweise versperrt.

11. Zweischichtige Rückseite nach Anspruch 10, wobei das erste Silikon ein Reaktionsprodukt zwischen Folgenden ist:
(A) einem Organopolysiloxan mit einem Polymerisationsgrad von weniger als oder gleich 150, terminiert mit mindestens zwei silikongebundenen R-Gruppen, wobei jede R-Gruppe unabhängig eine olefinisch ungesättigte Gruppe, eine Alkoxygruppe oder eine Hydroxylgruppe ist; und
(B) einem Organosilicium-Vernetzer mit mindestens 3 silikongebundenen Gruppen, die mit einer oder mehreren der R-Gruppen reagieren; bei Vorliegen von
(C) einer effektiven Menge eines Katalysators, der eine Reaktion zwischen (A) und (B) katalysiert, die das Silikon der zweiten äußersten Schicht bildet.

12. Verfahren zum Erzeugen von Elektrizität unter Verwendung eines Fotovoltaik-Zellmoduls, Folgendes umfassend:
eine erste äußerste Schicht mit einer Lichtdurchlässigkeit von mindestens 70 Prozent entsprechend der Bestimmung durch UV/Vis-Spektrofotometrie unter Verwendung von ASTM E424-71 (2007);
eine Fotovoltaik-Zelle, angeordnet auf der ersten äußersten Schicht;
eine Rückseite, angeordnet an der Fotovoltaik-Zelle; und
eine zweite äußerste Schicht gegenüber der ersten äußersten Schicht, wobei die zweite äußerste Schicht an der Rückseite angeordnet ist und die Fotovoltaik-Zelle und die Rückseite zwischen der zweiten äußersten Schicht und der ersten äußersten Schicht einklemmt,
wobei die zweite äußerste Schicht mit einem Auftragsgewicht von 3 bis 75 g/m² vorliegt,
wobei die Rückseite und die zweite äußerste Schicht jeweils unabhängig im Wesentlichen aus einem Silikon bestehen, und
wobei das Fotovoltaik-Zellmodul die Kriechstromprüfung unter Benässung bei einer Spannung von mindestens 1000 Volt unter Anwendung von IEC 61215 nach Feuchtigkeitswechsel über 1,000 Stunden besteht, wobei das Verfahren den Schritt der Exposition des Fotovoltaik-Zellmoduls gegenüber Sonnenlicht zum Erzeugen der Elektrizität umfasst.

13. Verfahren zum Versorgen einer elektrischen Einrichtung mit durch ein Fotovoltaik-Zellmodul erzeugter Elektrizität, Folgendes umfassend:
eine erste äußerste Schicht mit einer Lichtdurchlässigkeit von mindestens 70 Prozent entsprechend der Bestimmung durch UV/Vis-Spektrofotometrie unter Verwendung von ASTM E424-71 (2007);
eine Fotovoltaik-Zelle, angeordnet auf der ersten äußersten Schicht;
eine Rückseite, angeordnet an der Fotovoltaik-Zelle; und
eine zweite äußerste Schicht gegenüber der ersten äußersten Schicht, wobei die zweite äußerste Schicht an der Rückseite angeordnet ist und die Fotovoltaik-Zelle und die Rückseite zwischen der zweiten äußersten Schicht und der ersten äußersten Schicht einklemmt,
wobei die zweite äußerste Schicht mit einem Auftragsgewicht von 3 bis 75 g/m² vorliegt,
wobei die Rückseite und die zweite äußerste Schicht jeweils unabhängig im Wesentlichen aus einem Silikon bestehen, und
wobei das Fotovoltaik-Zellmodul die Kriechstromprüfung unter Benässung bei einer Spannung von mindestens 1000 Volt unter Anwendung von IEC 61215 nach Feuchtigkeitswechsel über 1.000 Stunden besteht,
wobei das Verfahren die folgenden Schritte umfasst:
Exposition des Fotovoltaik-Zellmoduls gegenüber Sonnenlicht zum Erzeugen der Elektrizität;
Übertragen der Elektrizität über eine elektrische Leitung vom Fotovoltaik-Zellmodul zu einer elektrischen Einrichtung zur Stromversorgung der elektrischen Einrichtung;
und Versorgung der elektrischen Einrichtung oder einer elektrischen Komponente davon mit der Elektrizität.

## Revendications

1. Module de cellule photovoltaïque comprenant :
A. une première couche la plus vers l'extérieur possédant une transmittance de la lumière d'au moins 70 pour cent telle que déterminée par spectrophotométrie UV/visible en utilisant ASTM E424-71 (2007) ;
B. une cellule photovoltaïque disposée sur ladite première couche la plus vers l'extérieur ;
C. une feuille de fond disposée sur ladite cellule photovoltaïque ; et
D. une deuxième couche la plus vers l'extérieur opposée à ladite première couche la plus vers l'extérieur, ladite deuxième couche la plus vers l'extérieur disposée sur une surface faisant face vers l'extérieur de ladite feuille de fond intercalant ladite cellule photovoltaïque et ladite feuille de fond entre ladite deuxième couche la plus vers l'extérieur et ladite première couche la plus vers l'extérieur,
dans lequel ladite deuxième couche la plus vers l'extérieur est présente à un poids de revêtement allant de 3 à 75 grammes par mètre carré de la surface faisant face vers l'extérieur de ladite feuille de fond,
dans lequel ladite feuille de fond et ladite deuxième couche la plus vers l'extérieur sont chacune indépendamment constituées pratiquement d'un silicone, et
où ledit module de cellule photovoltaïque réussit le test de courant de fuite mouillé à une tension d'au moins 1000 Volts en utilisant IEC 61215 après un cycle d'humidité pendant 1000 heures.

2. Module de cellule photovoltaïque selon la revendication 1, dans lequel ledit silicone de ladite deuxième couche la plus vers l'extérieur est un produit d'une réaction entre :
(A) un organopolysiloxane possédant un degré de polymérisation inférieur ou égal à 150 et terminé par au moins deux groupes R liés à du silicium, dans lequel chaque groupe R est indépendamment un groupe insaturé de façon oléfinique, un groupe alcoxy, ou un groupe hydroxyle ; et
(B) un agent réticulant organosilicié comportant au moins 3 groupes liés à du silicium, réactifs avec un ou plusieurs desdits groupes R ; en présence de
(C) une quantité efficace d'un catalyseur qui catalyse une réaction entre (A) et (B) qui forme le silicone de ladite deuxième couche la plus vers l'extérieur.

3. Module de cellule photovoltaïque selon la revendication 2, dans lequel (A) et (B) sont mis en réaction en présence d'une charge choisie parmi une charge métallique, une charge inorganique, une charge fusible, et des combinaisons de celles-ci et dans lequel ladite deuxième couche la plus vers l'extérieur comprend en outre ladite charge ; ou dans lequel (A) et (B) sont mis en réaction en présence de talc en une quantité de 2 à 70 pour cent en poids sur la base d'un poids total de ladite deuxième couche la plus vers l'extérieur et dans lequel ledit silicone de ladite deuxième couche la plus vers l'extérieur comprend en outre ledit talc ; ou dans lequel (A) et (B) sont mis en réaction conjointement en présence de dioxyde de titane en une quantité allant jusqu'à environ 30 pour cent en poids sur la base d'un poids total de ladite deuxième couche la plus vers l'extérieur dans lequel une quantité totale de dioxyde de titane et facultativement de talc ne dépasse pas 45 pour cent en poids sur la base d'un poids total de ladite deuxième couche la plus vers l'extérieur et dans lequel ledit silicone de ladite deuxième couche la plus vers l'extérieure comprend en outre ledit dioxyde de titane et facultativement ledit talc.

4. Module de cellule photovoltaïque selon l'une quelconque des revendications 2 à 3, dans lequel ledit catalyseur est un catalyseur d'hydrosilylation et ledit silicone de ladite deuxième couche la plus vers l'extérieur est un produit d'hydrosilylation d'une réaction entre (A) et (B) ; ou dans lequel ledit silicone de ladite deuxième couche la plus vers l'extérieur comprend un produit d'une réaction entre (A) et (B) ; ou dans lequel (A) comprend 10 à 50 pour cent molaires de motifs vinylméthylsiloxane sur la base d'un nombre total de moles de (A) ; ou dans lequel (A) comprend à la fois des groupes vinyle liés à du silicium et des groupes hydroxyle liés à du silicium dans une molécule unique.

5. Module de cellule photovoltaïque selon l'une quelconque des revendications précédentes, dans lequel ladite feuille de fond est constituée pratiquement d'un silicone différent en composition par rapport à la composition dudit silicone de ladite deuxième couche la plus vers l'extérieur.

6. Module de cellule photovoltaïque selon l'une quelconque des revendications précédentes, dans lequel ladite feuille de fond comprend en outre une pluralité de fibres ; ou dans lequel ladite feuille de fond comprend en outre une pluralité de fibres et dans lequel ladite pluralité de fibres est en outre décrite en tant que pluralité tissée de fibres.

7. Cellule photovoltaïque selon l'une quelconque des revendications précédentes, dans laquelle ladite deuxième couche la plus vers l'extérieur présente un coefficient de frottement de 0,1 à 0,7 vis-à-vis d'elle-même, mesuré selon ISO 8295.

8. Module de cellule photovoltaïque comprenant :
une première couche la plus vers l'extérieur possédant une transmittance de la lumière d'au moins 70 pour cent telle que déterminée par spectrophotométrie UV/visible en utilisant ASTM E424-71 (2007) ;
une cellule photovoltaïque possédant un côté avant et un côté arrière et disposée sur ladite première couche la plus vers l'extérieur ;
un agent d'encapsulation disposé sur, et en contact direct avec, ledit côté avant et ledit côté arrière de ladite cellule photovoltaïque,
une feuille de fond comprenant de la fibre de verre tissée et disposée sur ledit agent d'encapsulation ; et
une deuxième couche la plus vers l'extérieur opposée à ladite première couche la plus vers l'extérieur, ladite deuxième la plus vers l'extérieur étant disposée sur une surface faisant face vers l'extérieur de ladite feuille de fond intercalant ladite cellule photovoltaïque, ledit agent d'encapsulation, et ladite feuille de fond entre ladite deuxième couche la plus vers l'extérieur et ladite première couche la plus vers l'extérieur,
dans lequel ladite deuxième couche la plus vers l'extérieur est présente à un poids de revêtement allant de 10 à 20 grammes par mètre carré de la surface faisant face vers l'extérieur de ladite feuille de fond,
où ledit module de cellule photovoltaïque réussit le test de courant de fuite mouillé à une tension d'au moins 1000 Volts en utilisant IEC 61215 après un cycle d'humidité pendant 1000 heures,
dans lequel ladite deuxième couche la plus vers l'extérieur est le produit d'hydrosilylation d'une réaction entre :
un organopolysiloxane possédant une moyenne d'au moins deux groupes alcényle liés à du silicium ou atomes d'hydrogène liés à du silicium par molécule ; et
un composé organosilicié en une quantité suffisante pour durcir l'organopolysiloxane, dans lequel le composé organosilicié a une moyenne d'au moins deux atomes d'hydrogène liés à du silicium ou groupes alcényle liés à du silicium par molécule, susceptibles de réagir avec les groupes alcényle liés à du silicium ou les atomes d'hydrogène liés à du silicium dans l'organopolysiloxane ; en présence d'
une quantité catalytique d'un catalyseur d'hydrosilylation.

9. Procédé de formation d'un module de cellule photovoltaïque comprenant une première couche la plus vers l'extérieur possédant une transmittance de la lumière d'au moins 70 pour cent telle que déterminée par spectrophotométrie UV/visible en utilisant ASTM E424-71 (2007), une cellule photovoltaïque disposée sur la première couche la plus vers l'extérieur, une feuille de fond disposée sur la cellule photovoltaïque, et une deuxième couche la plus vers l'extérieur opposée à la première couche la plus vers l'extérieur et disposée sur une surface tournée vers l'extérieur de la feuille de fond intercalant la cellule photovoltaïque et la feuille de fond entre la deuxième couche la plus vers l'extérieur et la première couche la plus vers l'extérieur, dans lequel ladite deuxième couche la plus vers l'extérieur est présente en un poids de revêtement allant de 3 à 75 grammes par mètre carré de la surface faisant face vers l'extérieur de ladite feuille de fond, dans lequel ladite feuille de fond et ladite deuxième couche la plus vers l'extérieur sont chacune indépendamment constituées pratiquement d'un silicone, et dans lequel ledit module de cellule photovoltaïque réussit le test de courant de fuite mouillé à une tension d'au moins 1000 Volts en utilisant IEC 61215 après un cycle d'humidité pendant 1000 heures, ledit procédé comprenant l'étape consistant à assembler la première couche la plus vers l'extérieur, la cellule photovoltaïque, la feuille de fond et la deuxième couche la plus vers l'extérieur pour former le module de cellule photovoltaïque.

10. Feuille de fond bicouche pour un module de cellule photovoltaïque, ladite feuille de fond étant résistante à la salissure et à la délamination, possédant une épaisseur, et constituée pratiquement de :
A. un substrat perforé ; et
B. une couche anti-salissure disposée sur ledit substrat perforé et en contact direct avec les perforations dans ledit substrat perforé,
dans laquelle ladite couche anti-salissure a une épaisseur qui est inférieure à 10 pour cent de ladite épaisseur dudit substrat perforé,
dans laquelle ledit substrat perforé est constitué pratiquement d'un premier silicone,
dans laquelle ladite couche anti-salissure est constituée pratiquement d'un deuxième silicone différent dudit premier silicone et présente un coefficient de frottement de 0,1 à 0,7 vis-à-vis de lui-même, mesuré selon ISO 8295, et
dans laquelle ladite couche anti-salissure est disposée sur ledit substrat perforé à un poids de revêtement de 3 à 75 grammes par mètre carré dudit substrat perforé en bouchant au moins partiellement lesdites perforations.

11. Feuille de fond bicouche selon la revendication 10, dans laquelle ledit premier silicone est un produit d'une réaction entre :
(A) un organopolysiloxane possédant un degré de polymérisation inférieur ou égal à 150 et terminé par au moins deux groupes R liés à du silicium, dans lequel chaque groupe R est indépendamment un groupe insaturé de façon oléfinique, un groupe alcoxy, ou un groupe hydroxyle ; et
(B) un agent réticulant organosilicié comportant au moins 3 groupes liés à du silicium, réactifs avec un ou plusieurs desdits groupes R ; en présence de
(C) une quantité efficace d'un catalyseur qui catalyse une réaction entre (A) et (B) qui forme le silicone de ladite deuxième couche la plus vers l'extérieur.

12. Procédé de production d'électricité en utilisant un module de cellule photovoltaïque comprenant :
une première couche la plus vers l'extérieur possédant une transmittance de la lumière d'au moins 70 pour cent telle que déterminée par spectrophotométrie UV/visible en utilisant ASTM E424-71 (2007) ;
une cellule photovoltaïque disposée sur ladite première couche la plus vers l'extérieur ;
une feuille de fond disposée sur ladite cellule photovoltaïque , et
une deuxième couche la plus vers l'extérieur opposée à ladite première couche la plus vers l'extérieur, ladite deuxième couche la plus vers l'extérieur étant disposée sur une surface faisant face vers l'extérieur de ladite feuille de fond intercalant ladite cellule photovoltaïque et ladite feuille de fond entre ladite deuxième couche la plus vers l'extérieur et ladite première couche la plus vers l'extérieur,
dans lequel ladite deuxième couche la plus vers l'extérieur est présente à un poids de revêtement allant de 3 à 75 g/m²
dans lequel ladite feuille de fond et ladite deuxième couche la plus vers l'extérieur sont chacune indépendamment constituées pratiquement d'un silicone, et
dans lequel ledit module de cellule photovoltaïque réussit le test de courant de fuite mouillé à une tension d'au moins 1000 V en utilisant IEC 61215 après un cycle d'humidité pendant 1000 heures, où ledit procédé comprend l'étape consistant à exposer le module de cellule photovoltaïque à de la lumière solaire pour produire l'électricité.

13. Procédé d'alimentation d'un dispositif électrique avec de l'électricité produite par un module de cellule photovoltaïque comprenant :
une première couche la plus vers l'extérieur possédant une transmittance de la lumière d'au moins 70 pour cent telle que déterminée par spectrophotométrie UV/visible en utilisant ASTM E424-71 (2007) ;
une cellule photovoltaïque disposée sur ladite première couche la plus vers l'extérieur ;
une feuille de fond disposée sur ladite cellule photovoltaïque , et
une deuxième couche la plus vers l'extérieur opposée à ladite première couche la plus vers l'extérieur, ladite deuxième couche la plus vers l'extérieur disposée sur une surface faisant face vers l'extérieur de ladite feuille de fond intercalant ladite cellule photovoltaïque et ladite feuille de fond entre ladite deuxième couche la plus vers l'extérieur et ladite première couche la plus vers l'extérieur,
dans lequel ladite deuxième couche la plus vers l'extérieur est présente à un poids de revêtement allant de 3 à 75 g/m²,
dans lequel ladite feuille de fond et ladite deuxième couche la plus vers l'extérieur sont chacune indépendamment constituées pratiquement d'un silicone, et
dans lequel ledit module de cellule photovoltaïque réussit le test de courant de fuite mouillé à une tension d'au moins 1000 V en utilisant IEC 61215 après un cycle d'humidité pendant 1000 heures,
où ledit procédé comprend les étapes consistant à :
exposer le module de cellule photovoltaïque à de la lumière solaire pour produire l'électricité ;
transmettre l'électricité par l'intermédiaire d'un conduit électrique du module de cellule photovoltaïque à un dispositif électrique pour alimenter le dispositif électrique ;
et alimenter le dispositif électrique, ou un composant électrique de celui-ci, avec ladite électricité.
